# EUROPÄISCHE PATENTSCHRIFT

(11) **EP 1 957 605 B1**
(45) Veröffentlichungstag und Bekanntmachung des Hinweises auf die Patenterteilung: **11.01.2017**
(21) Anmeldenummer: 06829069.1
(22) Anmeldetag: 17.11.2006
(51) Int. Cl.: C09K 11/06, H01L 51/50, H01L 51/00

(54) **ORGANISCHE ELEKTROLUMINESZENZVORRICHTUNGEN**
ORGANIC ELECTROLUMINESCENT DEVICES
DISPOSITIFS ÉLECTROLUMINESCENTS ORGANIQUES

(30) Priorität: 08.12.2005 DE 102005058543
(43) Veröffentlichungstag der Anmeldung: 20.08.2008
(73) Patentinhaber: Merck Patent GmbH, 64293 Darmstadt (DE)
(72) Erfinder: HEIL, Holger, 64295 Darmstadt (DE); STOESSEL, Philipp, 60487 Frankfurt/Main (DE); FORTTE, Rocco, 65933 Frankfurt (DE); PARHAM, Amir, 65929 Frankfurt (DE); VESTWEBER, Horst, 34630 Gilersberg-Winterscheid (DE)
(86) Internationale Anmeldenummer: PCT/EP2006/011028
(87) Internationale Veröffentlichungsnummer: WO 2007/065549

(56) Entgegenhaltungen:
- EP-A- 1 074 601
- EP-A1- 0 866 110
- WO-A2-2004/058911
- JP-A- 4 184 892
- JP-A- 11 074 079
- US-A- 5 998 046
- CHA S W ET AL: "Balancing charge carrier mobility by constructing chemical structures to contain both hole- and electron-transporting moieties in electroluminescent organic compounds" SYNTHETIC METALS, ELSEVIER SEQUOIA, LAUSANNE, CH, Bd. 150, Nr. 3, 10. Mai 2005 (2005-05-10), Seiten 309-316, XP004912764 ISSN: 0379-6779
- LUPTON J M ET AL: "CONTROL OF ELECTROPHOSPHORESCENCE IN CONJUGATED DENDRIMER LIGHT-EMITTING DIODES" ADVANCED FUNCTIONAL MATERIALS, WILEY VCH, WIENHEIM, DE, Bd. 11, Nr. 4, August 2001 (2001-08), Seiten 287-294, XP001072704 ISSN: 1616-301X
- PALSSON L-O ET AL.: ""Synthesis and Excited State Spectroscopy of Tris(distyrylbenzeny)amine-cored Electroluminescent Dendrimers" MACROMOLECULES, Bd. 35, 2002, Seiten 7891-7901, XP002414562

## Beschreibung

Die vorliegende Erfindung betrifft organische Elektrolumineszenzvorrichtungen enthaltend Stilbenamine und Materialien zur Herstellung dieser Elektrolumineszenzvorrichtungen.

Der allgemeine Aufbau organischer Elektrolumineszenzvorrichtungen, die zur Emission von Licht im sichtbaren Spektralbereich befähigt sind und halbleitende organische Verbindungen enthalten, ist beispielsweise in US 4539507, US 5151629, EP 0676461 und WO 98/27136 beschrieben.

Allerdings zeigen diese Vorrichtungen immer noch erhebliche Probleme, die für die Verwendung in hochwertigen Vollfarbdisplays einer dringenden Verbesserung bedürfen. So ist insbesondere die operative Lebensdauer bei blauer Emission immer noch nicht ausreichend, so dass bis dato nur einfache Anwendungen kommerziell realisiert werden konnten.

In JP 04-184892 werden Distilbenamine, Tristilbenamine und weitere Stilbenderivate als emittierende Verbindungen für OLEDs beschrieben. Diese Verbindungen werden in der emittierenden Schicht als Reinsubstanz eingesetzt. Die Vorrichtungen mit den vorgeschlagenen Verbindungen weisen selbst in optimierten Device-Strukturen mit optimierten Hostmaterialien noch keine zufriedenstellenden Lebensdauern auf.

Es war daher Aufgabe der vorliegenden Erfindung, hierfür Verbesserungen anzubieten, insbesondere Verbindungen mit verbesserter Lebensdauer bei vergleichbar guten oder verbesserten tiefblauen Farbkoordinaten und bei vergleichbar guter Effizienz.

Überraschend wurde gefunden, dass organische Elektrolumineszenzvorrichtungen, die Tristilbenamin-Derivate mit bestimmten - im Folgenden aufgeführten - Substituenten in der emittierenden Schicht enthalten, deutliche Verbesserungen gegenüber dem Stand der Technik aufweisen. Mit diesen Materialien können verbesserte Lebensdauern bei weiterhin tiefblauer Emissionsfarbe und guter Effizienz erhalten werden. Dieses Ergebnis ist insbesondere daher überraschend, da ähnlich substituierte Emitter aus dem oben genannten Stand der Technik eine deutlich schlechtere Lebensdauer aufweisen. Diese Verbindungen und deren Verwendung in der emittierenden Schicht von OLEDs sind daher der Gegenstand der vorliegenden Erfindung.

Gegenstand der Erfindung sind organische Elektrolumineszenzvorrichtungen, enthaltend Anode, Kathode und mindestens eine organische Schicht, welche zur Emission von Licht befähigt ist, dadurch gekennzeichnet, dass die organische Schicht mindestens eine Verbindung der Formel (1) enthält, 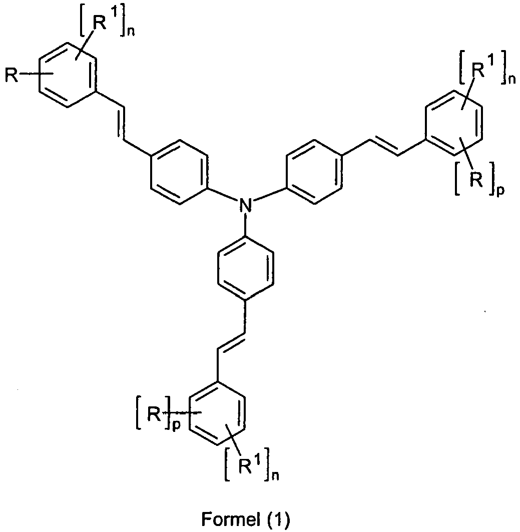 wobei für die verwendeten Symbole und Indizes gilt:
- R: ist gleich oder verschieden bei jedem Auftreten F, OCF₃, Si(R²)₃, B(OR²)₂ oder eine geradkettige, verzweigte oder cyclische Alkyl-, Alkoxy- oder Thioalkoxygruppe mit 4 bis 10 C-Atomen, die mit einem oder mehreren Resten R¹ substituiert sein kann, wobei eine oder mehrere nicht benachbarte CH₂-Gruppen durch -R²C=CR²-, -C≡C-, Si(R²)₂, Ge(R²)₂, Sn(R²)₂, C=O, C=S, C=Se, C=NR², -O-, -S-, -N(R²)- oder -CONR²- ersetzt sein können und wobei ein oder mehrere H-Atome durch F, Cl, Br, I, CN oder NO₂ ersetzt sein können; wenn R für eine Alkyl-, Alkoxy- oder Thioalkoxygruppe steht, kann R auch zwei Bindungen zur Phenylgruppe aufweisen und dadurch ein cyclisches, kondensiertes Ringsystem aufbauen;
- R¹: ist gleich oder verschieden bei jedem Auftreten F, Cl, Br, I, CN, Si(R²)₃, B(OR²)₂, eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch -R²C=CR²-, -C=C-, Si(R²)₂, Ge(R²)₂, Sn(R²)₂, C=O, C=S, C=Se, C=NR², -O-, -S-, -N(R²)- oder -CONR²- ersetzt sein können und wobei ein oder mehrere H-Atome durch F, Cl, Br, I, CN oder NO₂ ersetzt sein können, oder ein aromatisches oder heteroaromatisches Ringsystem mit 5 bis 30 aromatischen Ringatomen, das mit einem oder mehreren Resten R² substituiert sein kann, oder eine Aryloxy- oder Heteroaryloxygruppe mit 5 bis 24 aromatischen Ringatomen, die durch einen oder mehrere Reste R² substituiert sein kann, oder eine Kombination aus zwei, drei, vier oder fünf dieser Systeme; dabei können auch zwei oder mehrere Substituenten R¹ miteinander ein mono- oder polycyclisches, aliphatisches oder aromatisches Ringsystem bilden;
- R²: ist bei jedem Auftreten gleich oder verschieden H oder ein Kohlenwasserstoffrest mit 1 bis 20 C-Atomen, der aliphatisch, aromatisch oder eine Kombination aus aliphatisch und aromatisch sein kann und in dem auch einzelne H-Atome durch Fluor ersetzt sein können; dabei können auch zwei oder mehrere Reste R² miteinander ein mono- oder polycyclisches, aliphatisches oder aromatisches Ringsystem bilden;
- n: ist gleich oder verschieden bei jedem Auftreten 0, 1, 2, 3 oder 4;
- p: ist gleich oder verschieden bei jedem Auftreten 0 oder 1.

Unter einer cyclischen Alkylgruppe im Sinne dieser Erfindung werden sowohl monocyclische wie auch bi- und polycyclische Alkylgruppen verstanden.

Unter einer Arylgruppe bzw. einer Heteroarylgruppe im Sinne dieser Erfindung wird eine aromatische Gruppe bzw. heteroaromatische Gruppe mit einem gemeinsamen aromatischen π-Elektronensystem verstanden. Dies kann im Sinne dieser Erfindung ein einfacher Homo- oder Heterocyclus sein, beispielsweise Benzol, Pyridin, Thiophen, etc., oder es kann ein kondensiertes aromatisches Ringsystem sein, in dem mindestens zwei aromatische oder heteroaromatische Ringe, beispielsweise Benzolringe, miteinander "verschmolzen", d. h. durch Anellierung einander ankondensiert sind, also mindestens eine gemeinsame Kante und dadurch auch ein gemeinsames aromatisches π-Etektronensystem aufweisen. Diese Aryl- oder Heteroarylgruppen können substituiert oder unsubstituiert sein; ebenso können gegebenenfalls vorhandene Substituenten weitere Ringsysteme bilden. So sind beispielsweise Systeme wie Naphthalin, Anthracen, Phenanthren, Pyren, etc. als Arylgruppen und Chinolin, Acridin, Benzothiophen, Carbazol, etc. als Heteroarylgruppen im Sinne dieser Erfindung zu sehen, während beispielsweise Biphenyl, Fluoren, Spirobifluoren, etc. keine Arylgruppen darstellen, da es sich hierbei um separate aromatische π-Elektronensysteme handelt.

Ein aromatisches Ringsystem im Sinne dieser Erfindung enthält 6 bis 30 C-Atome im Ringsystem. Ein heteroaromatisches Ringsystem im Sinne dieser Erfindung enthält 2 bis 30 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine kurze, nicht-aromatische Einheit (weniger als 10 % der von H verschiedenen Atome, bevorzugt weniger als 5 % der von H verschiedenen Atome), wie z. B. ein sp³ hybridisiertes C-, N- oder O-Atom, unterbrochen sein können. So sollen beispielsweise auch Systeme wie 9,9'-Spirobifluoren, 9,9-Diarylfluoren, Triarylamin, Diarylether, etc. als aromatische Ringsysteme im Sinne dieser Erfindung verstanden werden. Dabei kann ein Teil des aromatischen oder heteroaromatischen Ringsystems auch eine kondensierte Gruppe sein.

Im Rahmen der vorliegenden Erfindung werden unter einer C₁- bis C₄₀-Alkylgruppe, in der auch einzelne H-Atome oder CH₂-Gruppen durch die oben genannten Gruppen substituiert sein können, besonders bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, Cyclopentyl, n-Hexyl, Cyclohexyl, n-Heptyl, Cycloheptyl, n-Octyl, Cyclooctyl, 2-Ethylhexyl, Adamantyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl oder Octinyl verstanden. Unter einer C₁- bis C₄₀-Alkoxygruppe werden besonders bevorzugt Methoxy, Ethoxy, n-Propoxy, i-Propoxy, n-Butoxy, i-Butoxy, s-Butoxy, t-Butoxy oder 2-Methylbutoxy verstanden. Unter einem aromatischen oder heteroaromatischen Ringsystem mit 1 bis 30 aromatischen Ringatomen, welches noch jeweils mit den oben genannten Resten R¹ bzw. R² substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Phenanthren, Pyren, Chrysen, Perylen, Fluoranthen, Tetracen, Pentacen, Benzpyren, Biphenyl, Biphenylen, Terphenyl, Terphenylen, Fluoren, Spirobifluoren, Truxen, Isotruxen, Dihydrophenanthren, Dihydropyren, Tetrahydropyren, cis- oder trans-Indenofluoren, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, Pyrazin, Phenazin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4 Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Im Folgenden werden bevorzugte Ausführungsformen für Verbindungen der Formel (1) beschrieben.

In einer bevorzugten Ausführungsform der Erfindung ist der Substituent R in para-Position zur Doppelbindung gebunden. Bevorzugte Verbindungen der Formel (1) sind also Verbindungen der Formel (1 a), 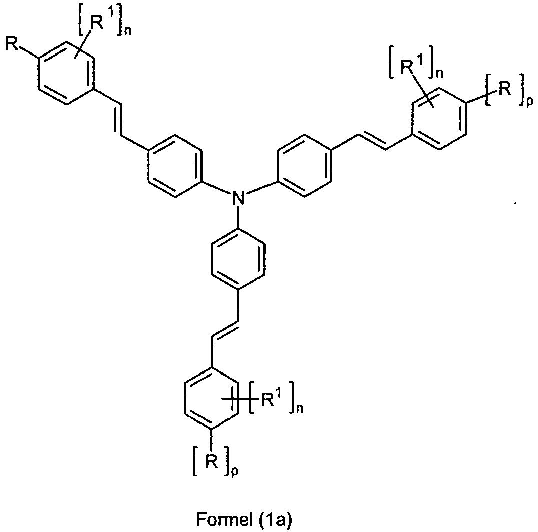 wobei die Symbole und Indizes dieselbe Bedeutung haben, wie oben beschrieben.

Bevorzugt sind Verbindungen der Formel (1), in denen das Symbol R, gleich oder verschieden bei jedem Auftreten, für F, Si(R²)₃, B(OR²)₂ oder eine geradkettige, verzweigte oder cyclische Alkylgruppe mit 4 bis 10 C-Atomen, wobei ein oder mehrere H-Atome durch F ersetzt sein können, steht. Besonders bevorzugt sind Verbindungen der Formel (1), in denen das Symbol R, gleich oder verschieden bei jedem Auftreten für Si(R²)₃, B(OR²)₂, eine verzweigte Alkylgruppe mit 4, 5 oder 6 C-Atomen oder eine cyclische Alkylgruppe mit 5 bis 10 C-Atomen, wobei jeweils auch ein oder mehrere H-Atome durch F ersetzt sein können, steht. Ganz besonders bevorzugte Gruppen Si(R²)₃ sind Si(Me)₃, Si(Me)₂(t-Bu), SiMe(t-Bu)₂ und Si(i-Pr)₃.

Bevorzugt sind weiterhin Verbindungen, in denen die Gruppe R keine benzylischen Protonen enthält, also keine Protonen, die an ein aliphatisches Kohlenstoffatom gebunden sind, welches direkt an die Phenylgruppe gebunden ist. Weiterhin bevorzugt sind Verbindungen, in denen das C-Atom der Gruppe R, welches direkt an die Phenylgruppe gebunden ist, ein Brückenkopfatom ist. Wenn R für eine Alkylgruppe steht, ist also das Kohlenstoffatom, welches direkt an die Phenylgruppe gebunden ist, bevorzugt ein quartäres C-Atom.

Bevorzugt sind weiterhin Verbindungen der Formel (1), in denen das Symbol R¹, gleich oder verschieden bei jedem Auftreten, für F, Si(R²)₃, B(OR²)₂, eine geradkettige Alkyl- oder Alkoxygruppe mit 1 bis 6 C-Atomen oder eine verzweigte oder cyclische Alkyl- oder Alkoxygruppe mit 3 bis 10 C-Atomen, wobei jeweils eine oder mehrere CH₂-Gruppen durch -R²C=CR²-, Si(R²)₂, -O-, -S- oder -N(R²)- ersetzt sein können und wobei jeweils ein oder mehrere H-Atome durch F ersetzt sein können, oder eine Aryl- oder Heteroarylgruppe mit 5 bis 14 aromatischen Ringatomen, oder eine Kombination aus zwei oder drei dieser Systeme steht; dabei können auch zwei oder mehrere benachbarte Reste R¹ miteinander ein mono- oder polycyclisches, aliphatisches Ringsystem bilden. Besonders bevorzugte Reste R¹ sind ausgewählt aus der Gruppe bestehend aus F, Si(R²)₃, B(OR²)₂, geradkettigen Alkylgruppen mit 1 bis 4 C-Atomen, verzweigten Alkylgruppen mit 3 bis 5 C-Atomen oder cyclischen Alkylgruppen mit 5 bis 10 C Atomen, wobei jeweils ein oder mehrere H-Atome durch F ersetzt sein können, oder monovalenten Aryl- oder Heteroarylgruppen mit 6 bis 10 aromatischen Ringatomen oder eine Kombination aus zwei dieser Systeme.

Bevorzugt sind weiterhin Verbindungen der Formel (1), in denen der Index n, gleich oder verschieden bei jedem Auftreten, für 0, 1, 2 oder 3, besonders bevorzugt für 0, 1 oder 2, ganz besonders bevorzugt für 0 oder 1 steht. Insbesondere bevorzugt ist der Index n = 0, das heißt, die Verbindung der Formel (1) trägt keine Substituenten R¹.

Bevorzugt sind weiterhin Verbindungen der Formel (1), in denen der Index p bei jedem Auftreten gleich 1 ist.

Bevorzugt sind weiterhin Verbindungen der Formel (1), in denen die Symbole R und, wenn vorhanden, R¹ alle gleich gewählt sind, also Verbindungen, die eine dreizählige Drehachse aufweisen.

Beispiele für besonders bevorzugte Verbindungen der Formel (1) sind die im Folgenden abgebildeten Verbindungen (1) bis (61).

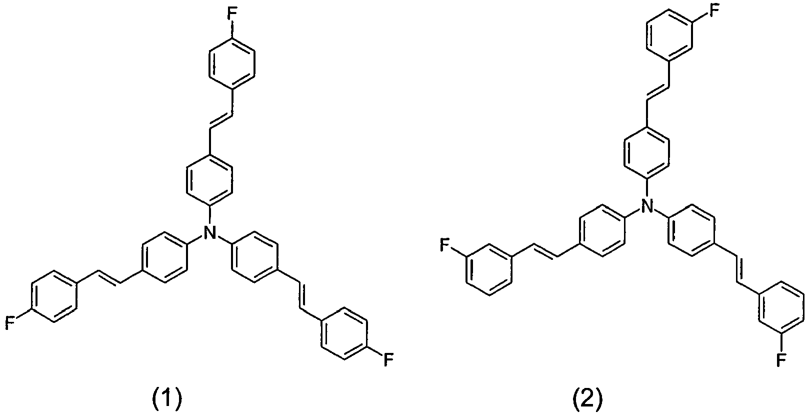

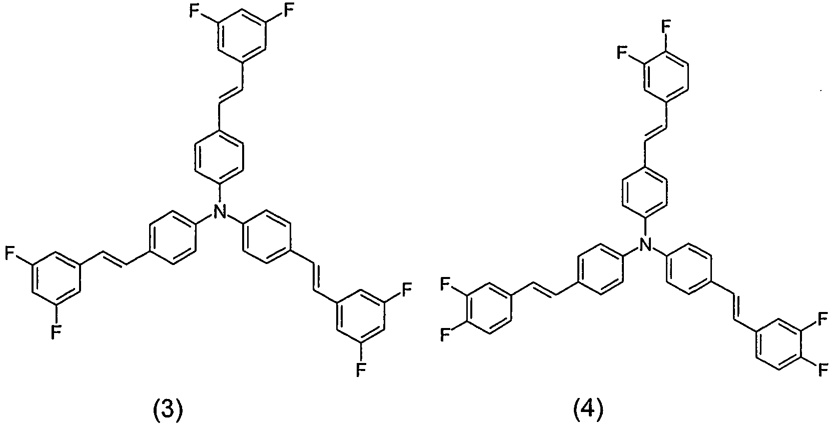

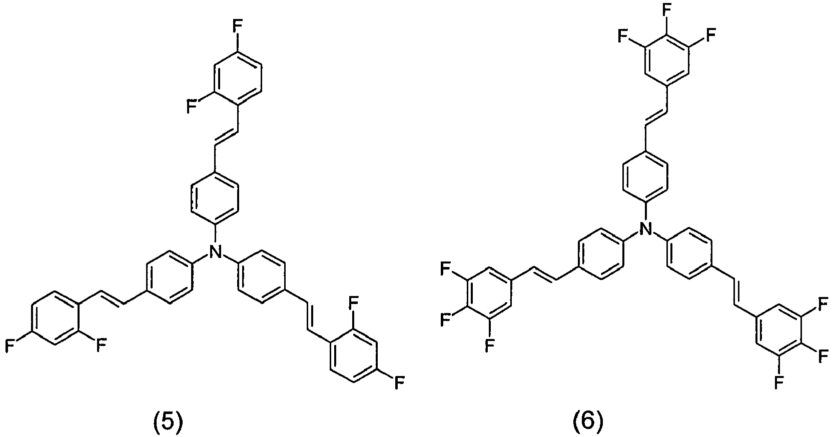

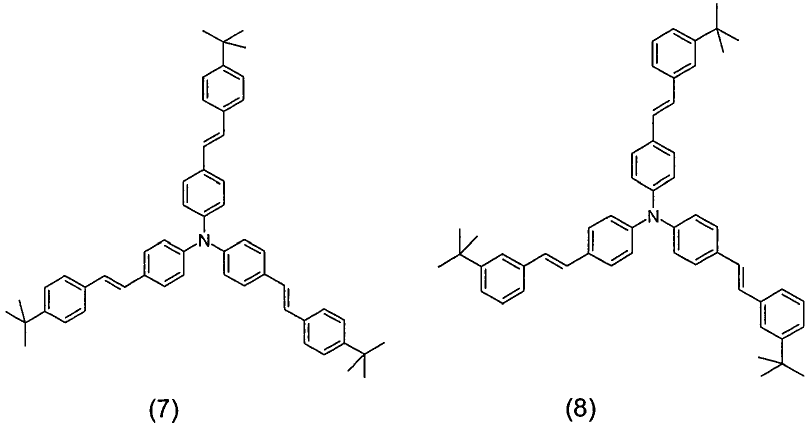

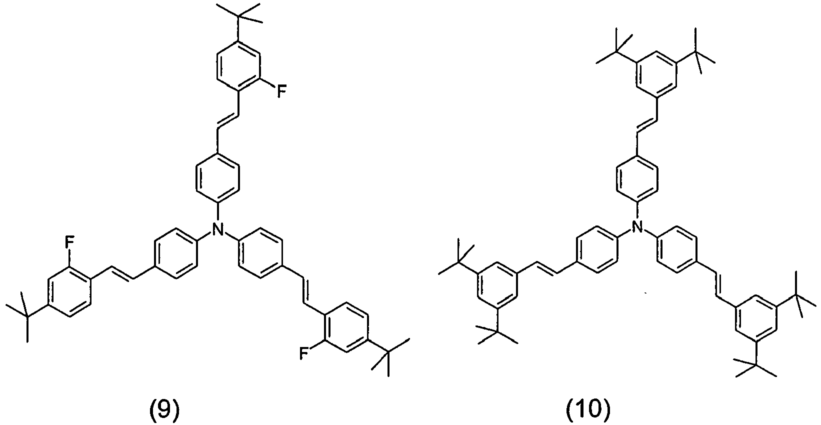

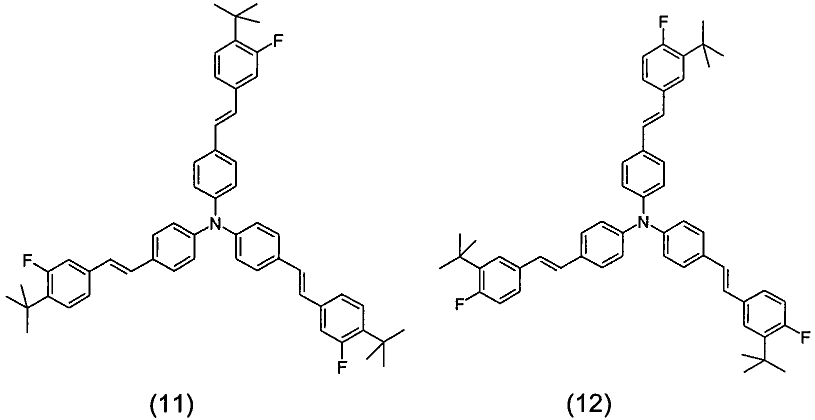

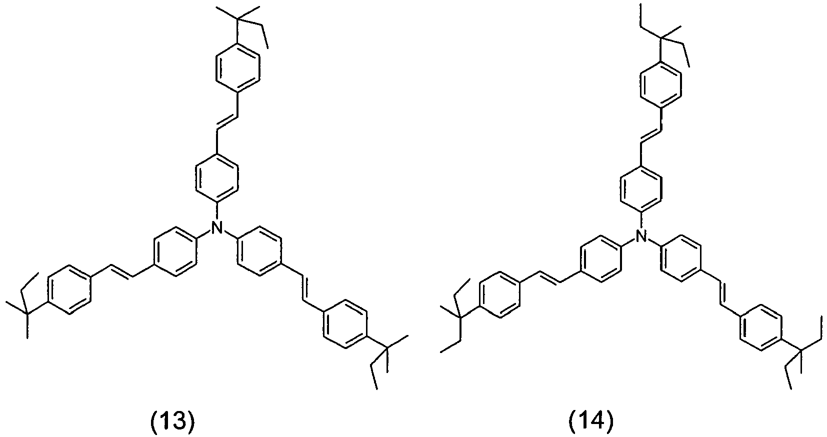

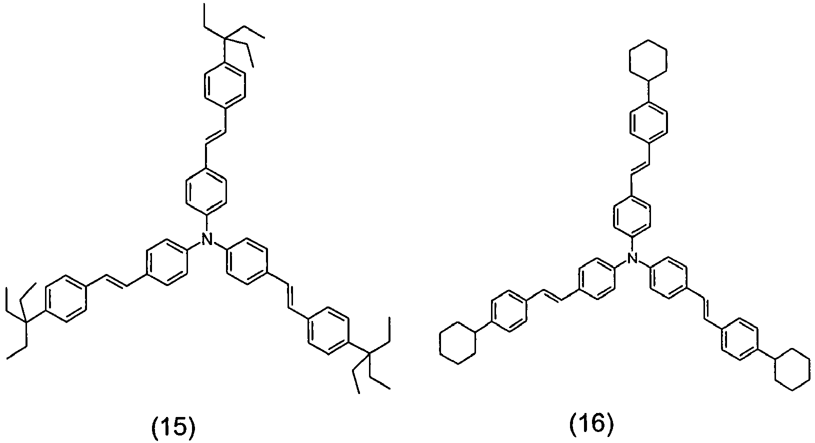

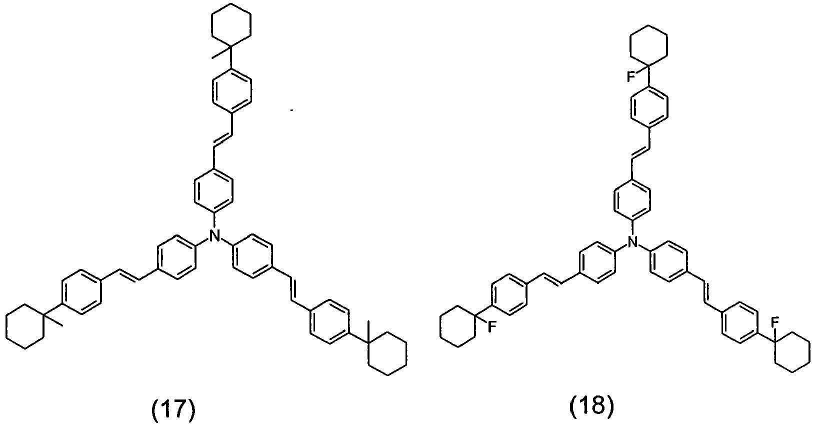

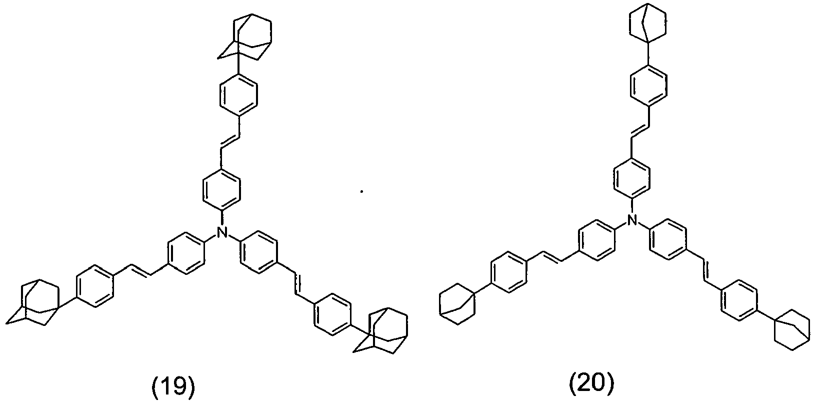

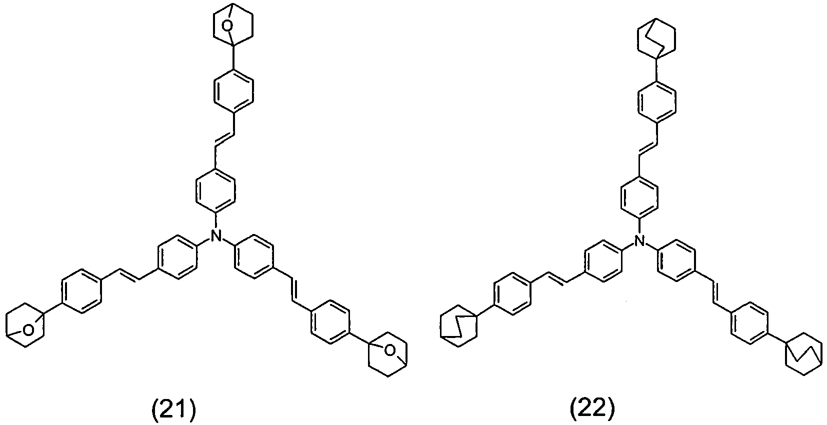

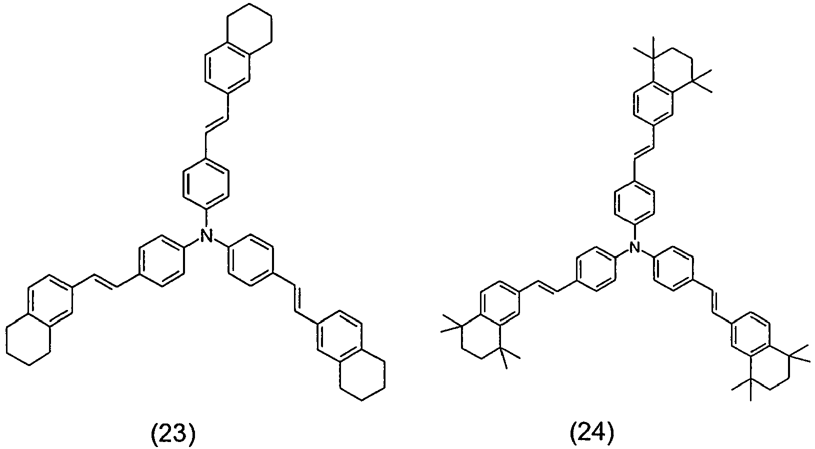

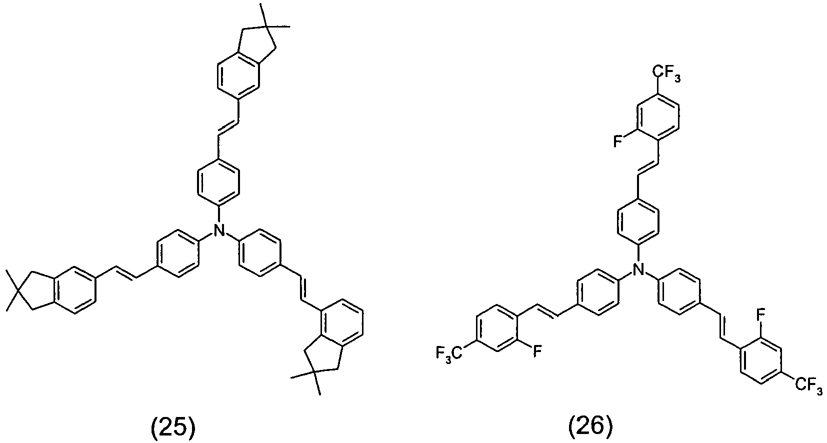

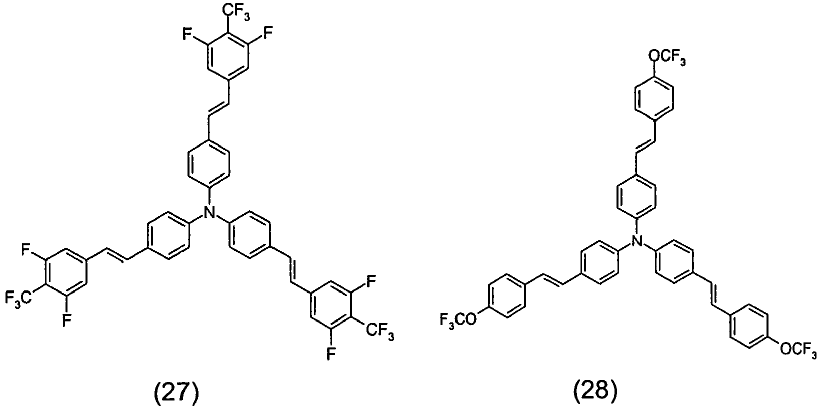

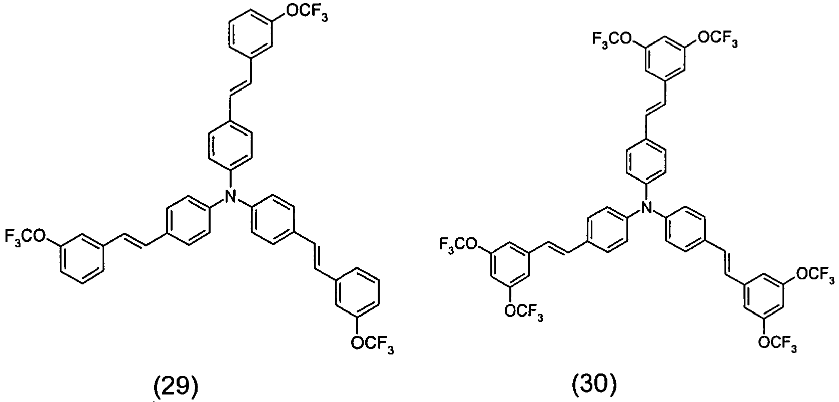

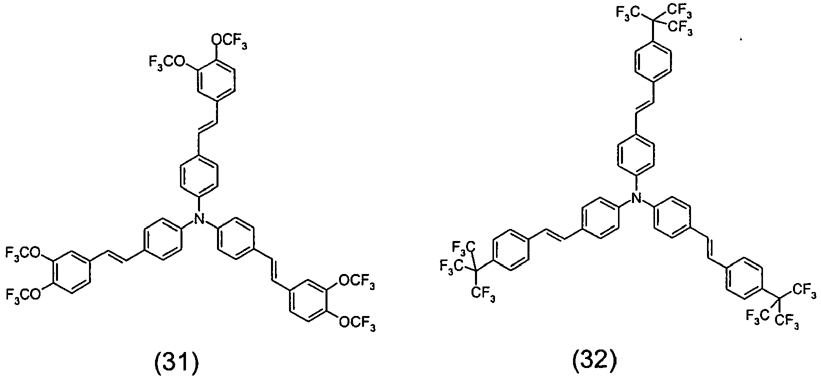

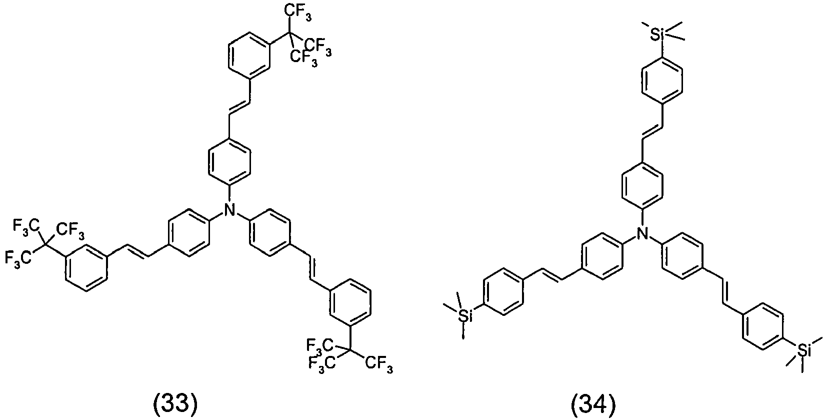

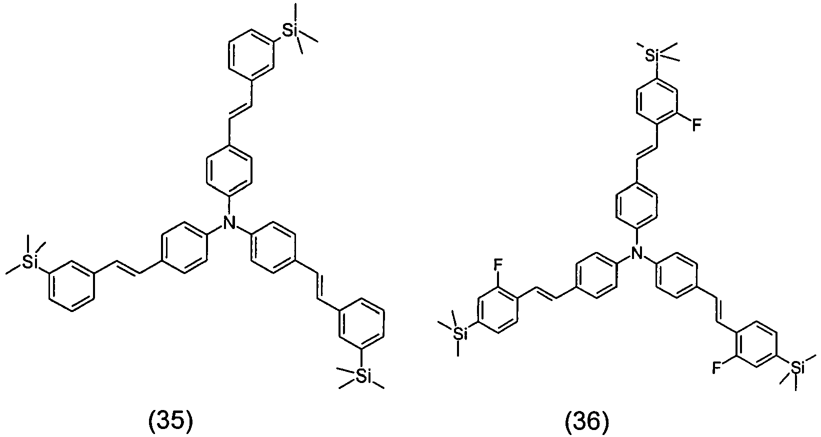

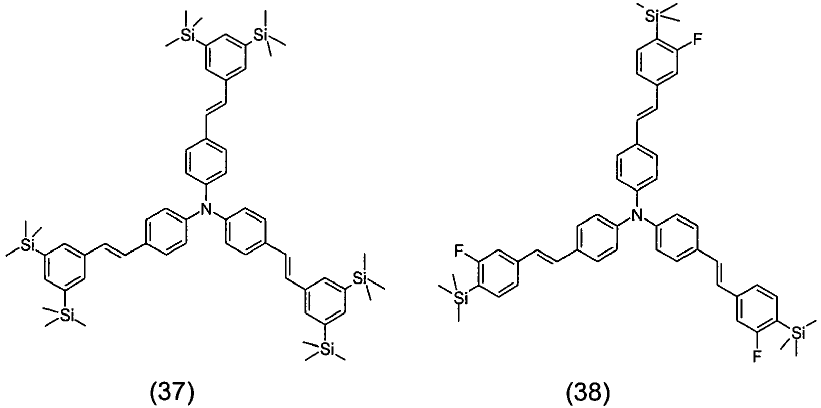

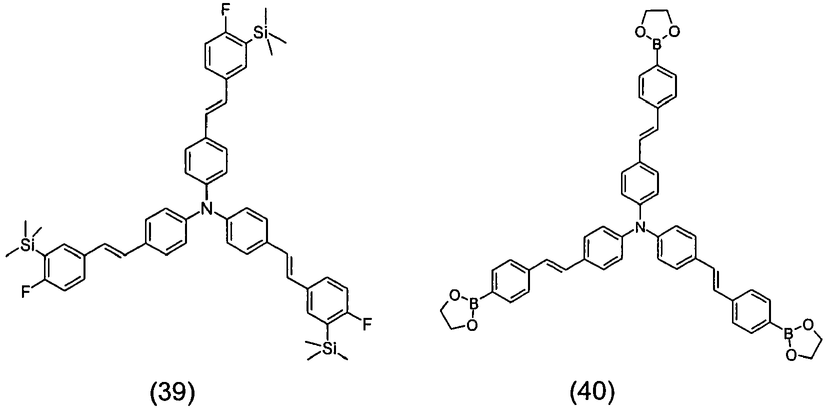

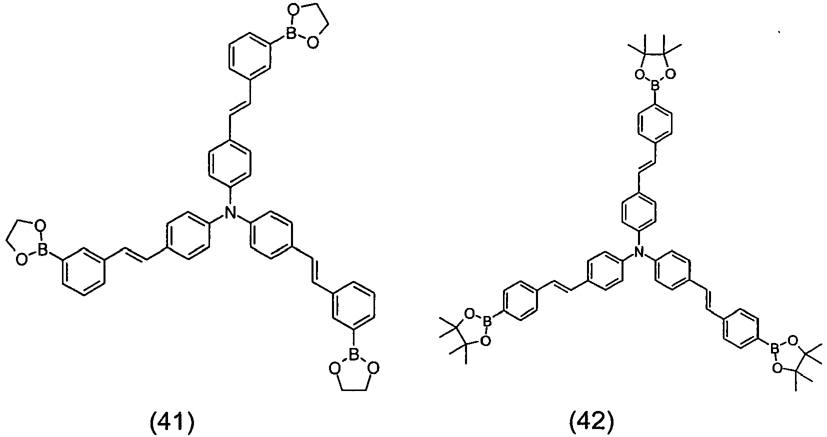

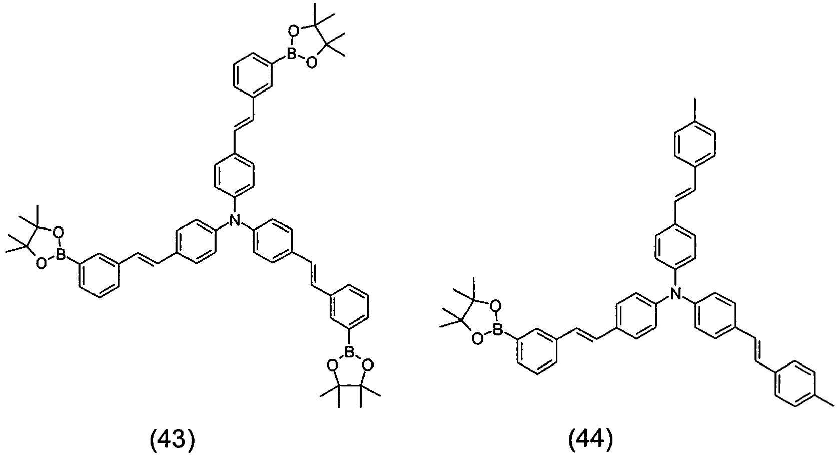

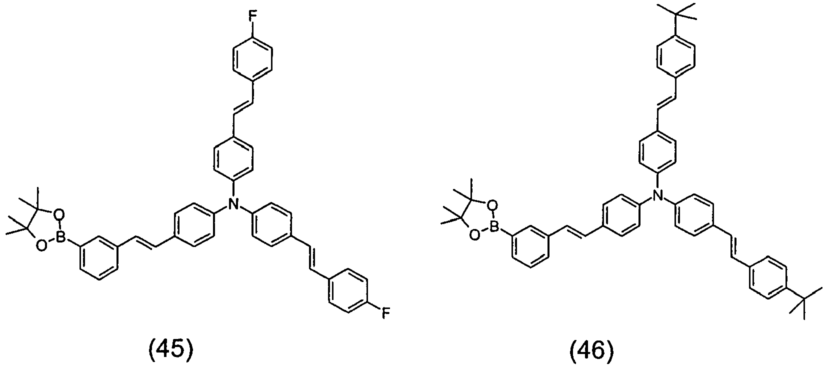

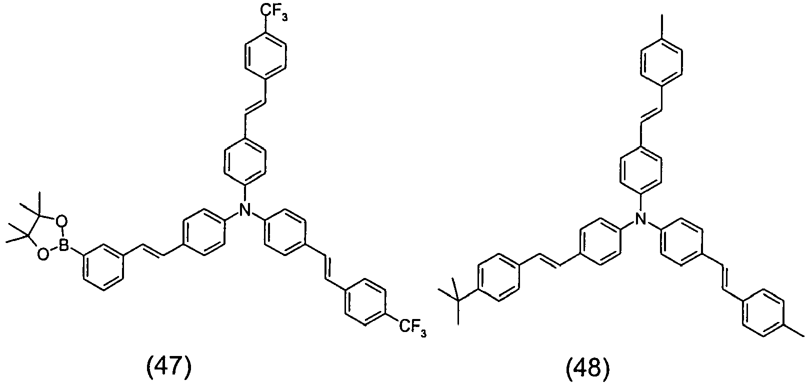

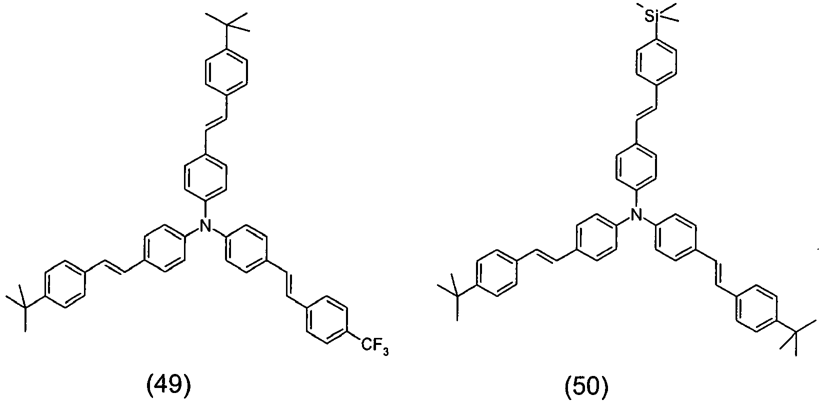

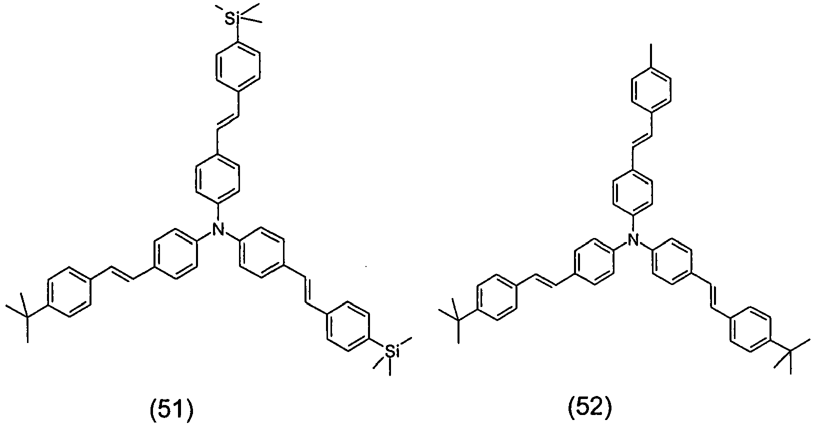

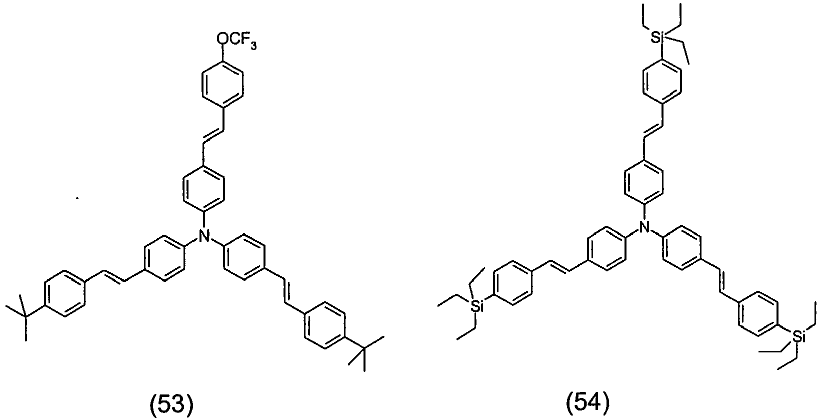

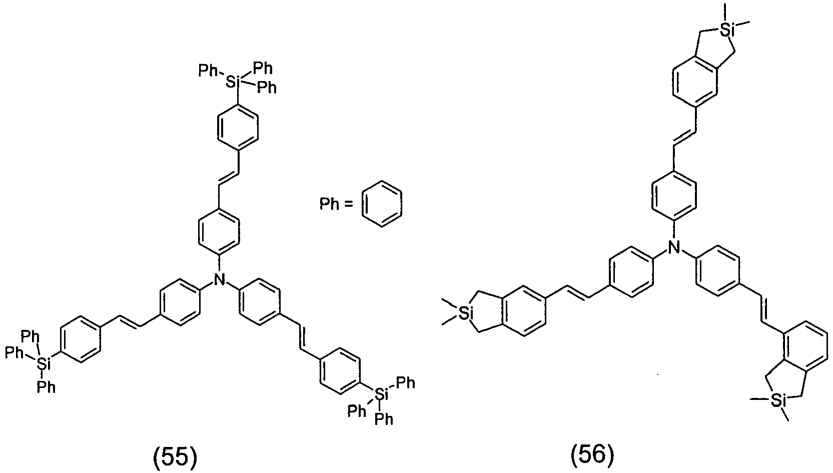

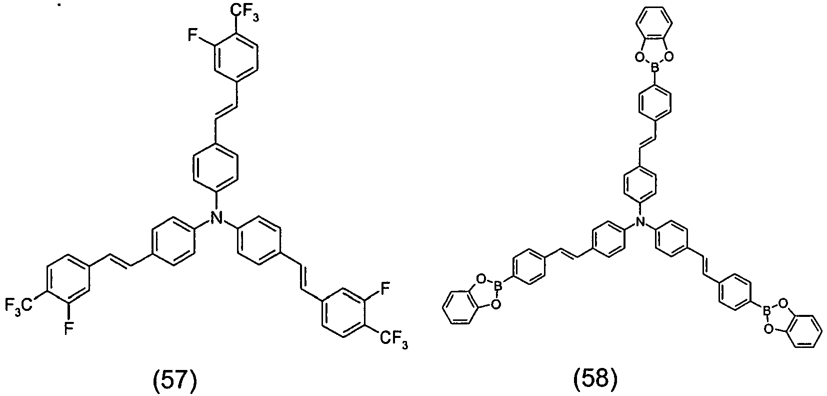

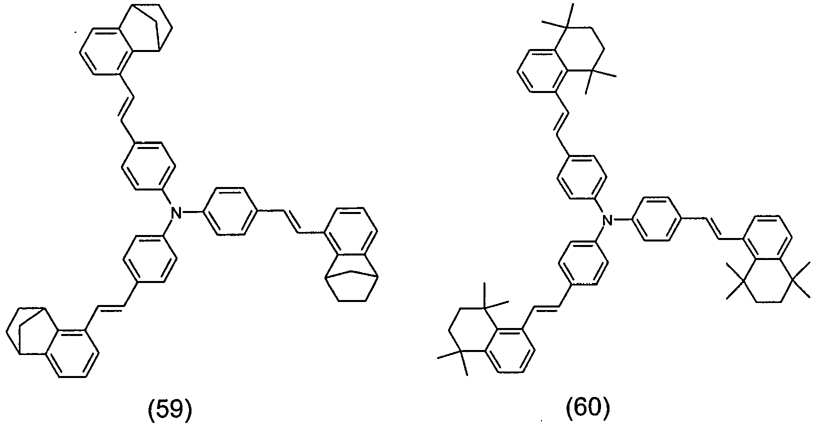

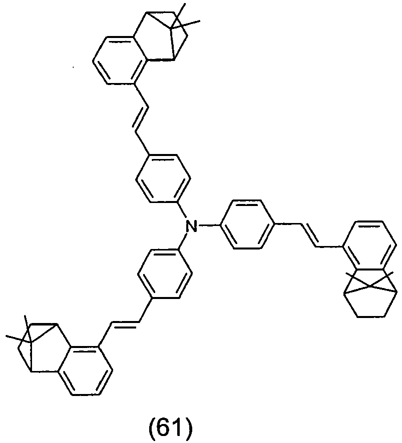

Die Verbindungen der Formel (1) werden bevorzugt in der emittierenden Schicht, besonders bevorzugt als Mischung mit einem Hostmaterial, verwendet. Als Hostmaterialien kommen verschiedene Stoffklassen in Frage. Bevorzugte Hostmaterialien sind ausgewählt aus den Klassen der Oligo-arylene (z. B. 2,2',7,7'-tetraphenyl-spirobifluoren gemäß EP 676461 oder Dinaphthylanthracen), insbesondere der Oligo-arylene enthaltend kondensierte aromatische Gruppen, der Oligo-arylenvinylene (z. B. DPVBi (Bis-diphenylvinylbiphenyl) oder Spiro-DPVBi gemäß EP 676461), der polypodalen Metallkomplexe (z. B. gemäß WO 04/081017), der lochleitenden Verbindungen (z. B. gemäß WO 04/058911), insbesondere der Triarylamin-Derivate und der Carbazol-Derivate, der elektronenleitenden Verbindungen, insbesondere Ketone, Phosphinoxide, Sulfoxide, etc. (z. B. gemäß WO 05/084081 und WO 05/084082), der Atropisomere (z. B. gemäß WO 06/048268), der Ansa-Verbindungen (z. B. gemäß der nicht offen gelegten Anmeldung EP 05005709.0), der Cycloalkylphenylanthracene (z. B. gemäß der nicht offen gelegten Anmeldung DE 102005026651.7) oder der Boronsäurederivate (z. B. gemäß der nicht offen gelegten Anmeldung EP 05009643.7). Besonders bevorzugte Hostmaterialien sind ausgewählt aus den Klassen der Oligoarylene, enthaltend Naphthalin, Anthracen, Pyren und/oder Perylen oder Atropisomeren dieser Verbindungen, der Ketone, der Phosphinoxide, der Sulfoxide und der Boronsäurederivate. Ganz besonders bevorzugte Hostmaterialien sind ausgewählt aus den Klassen der Oligoarylene, enthaltend Anthracen und/oder Pyren oder Atropisomeren dieser Verbindungen und der Phosphinoxide.

Der Anteil der Verbindung gemäß Formel (1) in der Mischung beträgt zwischen 0.1 und 99.0 Gew.-%, bevorzugt zwischen 0.5 und 50.0 Gew.-%, besonders bevorzugt zwischen 1.0 und 20.0 Gew.-%, insbesondere zwischen 1.0 und 10.0 Gew.-%. Entsprechend beträgt der Anteil des Hostmaterials in der Mischung zwischen 1.0 und 99.9 Gew.-%, bevorzugt zwischen 50.0 und 99.5 Gew.-%, besonders bevorzugt zwischen 80.0 und 99.0 Gew.-%, insbesondere zwischen 90.0 und 99.0 Gew.-%. Als Hostmaterial wird diejenige Verbindung bezeichnet, die in der Mischung der emittierenden Schicht im größten Anteil vorkommt.

Weiterhin bevorzugt sind organische Elektrolumineszenzvorrichtungen, dadurch gekennzeichnet, dass mehrere emittierende Schichten verwendet werden, wobei mindestens eine dieser Schichten mindestens eine Verbindung gemäß Formel (1) enthält, bevorzugt in Kombination mit einem Hostmaterial. Besonders bevorzugt weisen diese Emissionsschichten insgesamt mehrere Emissionsmaxima zwischen 380 nm und 750 nm auf, so dass insgesamt weiße Emission resultiert, d. h. in der bzw. den weiteren emittierenden Schichten wird noch mindestens eine weitere emittierende Verbindung verwendet, die fluoreszieren oder phosphoreszieren kann und die gelbes, orange oder rotes Licht emittiert. Insbesondere bevorzugt sind Dreischichtsysteme, wobei mindestens eine dieser Schichten mindestens eine Verbindung gemäß Formel (1) enthält, bevorzugt in Verbindung mit einem Hostmaterial und wobei die drei Schichten blaue, grüne und orange oder rote Emission zeigen (für den prinzipiellen Aufbau siehe z. B. WO 05/011013).

Außer Kathode, Anode und der emittierenden Schicht (bzw. den emittierenden Schichten) kann die organische Elektrolumineszenzvorrichtung noch weitere Schichten enthalten. Diese können beispielsweise sein: Lochinjektionsschicht, Lochtransportschicht, Elektronentransportschicht und/oder Elektroneninjektionsschicht. Diese Schichten können auch dotiert sein. Es muss aber nicht notwendigerweise jede dieser Schichten vorhanden sein. Als Lochtransportmaterialien eignen sich insbesondere aromatische Amine, wie sie überlicherweise gemäß dem Stand der Technik verwendet werden. Die Lochtransportschicht kann auch p-dotiert sein. Als Elektronentransportmaterialien eignen sich beispielsweise Metallchelatkomplexe, z. B. AlQ₃, Verbindungen auf Basis elektronenarmer Heterocyclen, z. B. Triazinderivate, oder Verbindungen enthaltend aromatische Ketone oder Phosphinoxide, wie z. B. beschrieben in WO 05/084081 und WO 05/084082. Die Elektronentransportschicht kann auch n-dotiert sein, z. B. AlQ₃ dotiert mit Cs. Als Elektroneninjektionsmaterialien eignen sich insbesondere Fluoride und Oxide der Alkali- und Erdalkalimetalle, beispielsweise NaF, BaF₂, CaF₂, LiF oder Li₂O.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Druck kleiner 10⁻⁵ mbar, bevorzugt kleiner 10⁻⁶ mbar, besonders bevorzugt kleiner 10⁻⁷ mbar aufgedampft.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht.

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck oder Offsetdruck, besonders bevorzugt aber LITI (Light Induced Thermal Imaging, Thermotransferdruck) oder Ink-Jet Druck (Tintenstrahldruck), hergestellt werden. Hierfür sind lösliche Verbindungen gemäß Formel (1) nötig. Hohe Löslichkeit lässt sich durch geeignete Substitution der Verbindungen erreichen.

Weiterer Gegenstand sind Mischungen enthaltend mindestens eine Verbindung gemäß Formel (1) und mindestens ein Hostmaterial.

Nochmals ein weiterer Gegenstand der Erfindung ist die Verwendung von Verbindungen gemäß Formel (1) zur Herstellung organischer Elektrolumineszenzvorrichtungen. Ebenfalls ein weiterer Gegenstand der Erfindung ist die Verwendung von Mischungen, enthaltend mindestens eine Verbindung der Formel (1) und mindestens ein Hostmaterial, zur Herstellung von organischen Elektrolumineszenzvorrichtungen.

Die Verbindungen der Formel (1) sind neu und sind daher ebenfalls Gegenstand der vorliegenden Erfindung.

Gegenstand der Erfindung sind daher weiterhin Verbindungen der Formel (1). 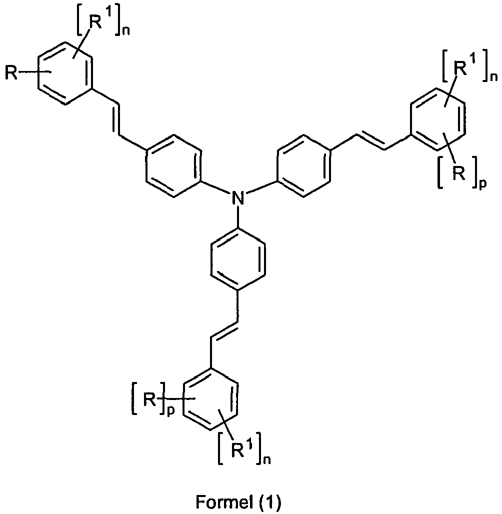 wobei R, R¹, R², n und p dieselbe Bedeutung haben, wie oben beschrieben, wobei die folgende Verbindung von der Erfindung ausgeschlossen ist:

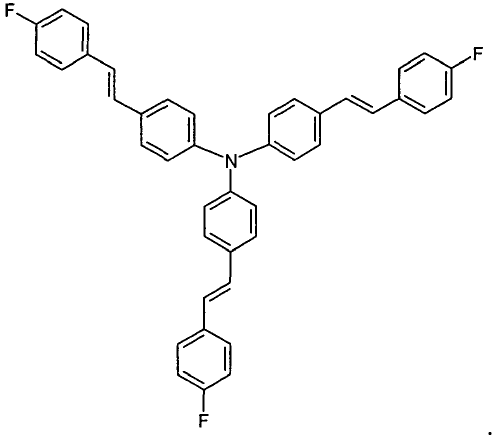

In einer bevorzugte Ausführungsform der Erfindung ist der Rest R, gleich oder verschieden bei jedem Auftreten OCF₃, Si(R²)₃, B(OR²)₂ oder eine verzweigte oder cyclische Alkyl-, Alkoxy- oder Thioalkoxygruppe mit 4 bis 10 C-Atomen, die mit einem oder mehreren Resten R¹ substituiert sein kann, wobei eine oder mehrere nicht benachbarte CH₂ Gruppen durch -R²C=CR²-, -C≡C- , Si(R²)₂, Ge(R²)₂, Sn(R²)₂, C=O, C=S, C=Se, C=NR², -O-, -S-, -N(R²)- oder -CONR²- ersetzt sein können und wobei ein oder mehrere H-Atome durch F, Cl, Br, I, CN oder NO₂ ersetzt sein können, oder eine Arylgruppe mit 6 bis 16 C-Atomen, welche durch R² substituiert sein kann; wenn R für eine Alkyl-, Alkoxy- oder Thioalkoxygruppe steht, kann R auch zwei Bindungen zur Phenylgruppe aufweisen und dadurch ein cyclisches, kondensiertes Ringsystem aufbauen.

Bevorzugte Verbindungen der Formel (1) sind die oben bereits für die Verwendung in OLEDs aufgeführten bevorzugten Ausführungsformen.

Die Verbindungen der Formel (1) lassen sich in Analogie zu den Verbindungen gemäß dem Stand der Technik synthetisieren. So lassen sie sich beispielsweise durch eine Heck-Kupplung von Tris-(4-bromphenyl)amin mit einem entsprechend substituierten Styrolderivat synthetisieren. Eine besonders geeignete Variante der Heck-Kupplung ist beispielsweise in WO 02/10093 beschrieben. Weitere Synthesevarianten der Heck-Kupplung sind in der in WO 02/10093 zitierten Literatur beschrieben. Dieses Verfahren kann verwendet werden, wenn der Substituent am Styrolderivat nicht selber unter den Bedingungen der Heck-Kupplung reagiert. So lassen sich beispielsweise Alkyl-substituierte Verbindungen der Formel (1) nach diesem Verfahren aus Alkylsubstituierten Styrolderivaten synthetisieren. Ein weiteres Verfahren ist die Reaktion nach Wittig-Horner, in der ein entsprechend substituiertes Dialkylbenzylphosphonat, wobei die Alkylgruppe bevorzugt 1 bis 10 C-Atome, besonders bevorzugt 1 oder 2 C-Atome aufweist, mit Tris(4-formylphenyl)amin umgesetzt wird. Auch nach diesem Verfahren sind substituierte Tristilbenamine zugänglich, beispielsweise auch Bromsubstituierte Tristilbenamine. Dieser Bromsubstituent kann dann in einem Folgeschritt gegen andere funktionelle Gruppen ausgetauscht werden, beispielsweise durch Metallierung, z. B. durch Umwandlung in das entsprechende Grignard-Reagenz oder durch Lithiierung, und kann mit beispielsweise einem Silylhalogenid in das entsprechenden Silylderivat und mit einem Borat in die entsprechenden Boronsäurederivate überführt werden. Ebenso kann nach diesem Verfahren die funktionelle Gruppe der Verbindung der Formel (1) direkt als Substituent am Edukt anwesend sein, beispielsweise eine Silylgruppe oder eine Boronsäureestergruppe.

Ein weiterer Gegenstand der Erfindung ist daher ein Verfahren zur Synthese von Verbindungen gemäß Formel (1), dadurch gekennzeichnet, dass Tris-(4-bromphenyl)amin mit einem entsprechend substituierten Styrolderivat in einer Heck-Kupplung umgesetzt wird oder dass Tris(4-formylphenyl)amin mit einem entsprechend substituierten Dialkylbenzylphosphonat umgesetzt wird, gegebenenfalls gefolgt von einer Umsetzung des ursprünglichen Substituenten zum Zielsubstituenten.

Ein nochmals weiterer Gegenstand der Erfindung ist die Verwendung von Verbindungen gemäß Formel (1) in organischen Feld-Effekt-Transistoren (O-FETs), organischen Dünnfilmtransistoren (O-TFTs), organischen lichtemittierenden Transistoren (O-LETs), organischen integrierten Schaltungen (O-ICs), organischen Solarzellen (O-SCs), organischen Feld-Quench-Devices (O-FQDs), lichtemittierenden elektrochemischen Zellen oder organischen Laserdioden (O-Laser).

Die erfindungsgemäßen organischen Elektrolumineszenzvorrichtungen weisen folgenden überraschenden Vorteil gegenüber dem Stand der Technik auf: Die Stabilität der Vorrichtungen wird höher im Vergleich zu Systemen gemäß dem Stand der Technik, was sich vor allem in einer deutlich höheren Lebensdauer zeigt. Dieses Ergebnis ist vor allem deshalb überraschend, da OLEDs, die Tristilbenamine enthalten, welche unsubstituiert oder mit ähnlichen Substituenten, beispielsweise Methyl- oder iso-Propylgruppen, substituiert sind, eine geringere Lebensdauer aufweisen. Weiterhin zeigen die erfindungsgemäßen Vorrichtungen verbesserte tiefblaue Farbkoordinaten im Vergleich zu Vorrichtungen, die Tristilbenamin-Derivate gemäß dem Stand der Techik enthalten.

Die Erfindung wird durch die nachfolgenden Beispiele näher erläutert, ohne sie dadurch einschränken zu wollen.

### Beispiele:

Die nachfolgenden Synthesen werden, sofern nicht anders angegeben, unter einer Schutzgasatmosphäre durchgeführt. Die Edukte können von der Firma ALDRICH (Tris-(4-bromphenyl)amin, 4-tert-Butylstyrol, 4-Fluorstyrol, Palladium(II)acetat, N,N-Dimethylglycin, Anorganika, Lösemittel) und von Epsilon Chimie Products (Diethyl(4-brombenzyl)phosphonat) bezogen werden. Tris(4-formylphenyl)amin kann gemäß Synthesis 2005, 11, 1771 dargestellt werden. Tris[(phenylvinyl)phenyl]amin kann gemäß Macromolecules 1996, 29, 7705 synthetisiert werden. 4-Trifluormethoxystyrol kann gemäß J. Org. Chem. 1964, 29, 1 dargestellt werden. 6-Ethenyl-1,2,3,4-tetrahydro-1,1,4,4-tetramethyl-naphthalin kann gemäß J. Med. Chem. 1989, 32, 1504 dargestellt werden.

### Beispiel 1: Tris(phenylvinylphenyl)amin (Dotand D1, Vergleich)

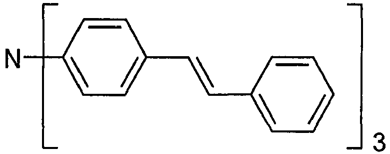

Ein Gemisch aus 24.1 g (50 mmol) Tris-(4-bromphenyl)amin, 25.8 ml (225 mmol) Styrol, 337 mg (1.5 mmol) Palladium(II)acetat, 1.55 g (15 mmol) N,N-Dimethylglycin, 81 mg (0.5 mmol) Eisen(III)chlorid und 37.8 g (450 mmol) Natriumhydrogencarbonat in 500 ml NMP wird langsam unter gutem Rühren auf 140 °C erhitzt und anschließend 16 h bei dieser Temperatur gerührt. Nach Erkalten werden 500 ml Dichlormethan und 1000 ml Wasser zugesetzt. Die organische Phase wird abgetrennt und fünfmal mit je 500 ml Wasser gewaschen. Nach Trocknen über Natriumsulfat wird die organische Phase zur Trockene eingeengt. Der so erhaltene gelbe Feststoff wird sechsmal aus Toluol umkristallisiert, dann zweimal mit je 500 ml Ethanol unter Rückfluss ausgerührt und anschließend dreimal im Vakuum (T = 350 °C, p = 5 x 10⁻⁵ mbar) sublimiert. Es werden 18.8 g (34 mmol) (entsprechend 68.1 % d. Th.) des Produkts mit einer Reinheit größer 99.5 % nach HPLC erhalten.

### Beispiel 2: Tris[4-(methylphenylvinyl)phenyl]amin (Dotand D2, Vergleich)

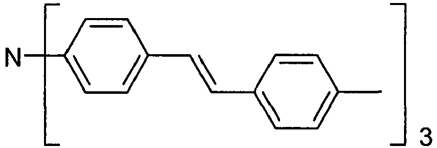

Ein Gemisch aus 24.1 g (50 mmol) Tris-(4-bromphenyl)amin, 29.6 ml (225 mmol) 4-Methylstyrol, 337 mg (1.5 mmol) Palladium(II)acetat, 1.55 g (15 mmol) N,N-Dimethylglycin, 81 mg (0.5 mmol) Eisen(III)chlorid und 37.8 g (450 mmol) Natriumhydrogencarbonat in 500 ml NMP wird langsam unter gutem Rühren auf 140 °C erhitzt und anschließend 16 h bei dieser Temperatur gerührt. Nach Erkalten werden 500 ml Dichlormethan und 1000 ml Wasser zugesetzt. Die organische Phase wird abgetrennt und fünfmal mit je 500 ml Wasser gewaschen. Nach Trocknen über Natriumsulfat wird die organische Phase zur Trockene eingeengt. Der so erhaltene gelbe Feststoff wird sechsmal aus Toluol umkristallisiert, dann zweimal mit je 500 ml Ethanol unter Rückfluss ausgerührt und anschließend dreimal im Vakuum (T = 350 °C, p = 5 x 10⁻⁵ mbar) sublimiert. Es werden 15.7 g (26 mmol) (entsprechend 52.8 % d. Th.) des Produkts mit einer Reinheit größer 99.5 % nach HPLC erhalten.

### Beispiel 3: Tris[4-(tert-butylphenylvinyl)phenyl]amin (Dotand D3)

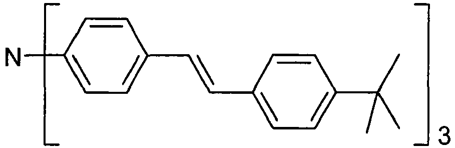

Ein Gemisch aus 24.1 g (50 mmol) Tris-(4-bromphenyl)amin, 42.4 ml (225 mmol) 4-tert-Butylstyrol, 337 mg (1.5 mmol) Palladium(II)acetat, 1.55 g (15 mmol) N,N-Dimethylglycin, 81 mg (0.5 mmol) Eisen(III)chlorid und 37.8 g (450 mmol) Natriumhydrogencarbonat in 500 ml NMP wird langsam unter gutem Rühren auf 140 °C erhitzt und anschließend 16 h bei dieser Temperatur gerührt. Nach Erkalten werden 500 ml Dichlormethan und 1000 ml Wasser zugesetzt. Die organische Phase wird abgetrennt und fünfmal mit 500 ml Wasser gewaschen. Nach Trocknen über Natriumsulfat wird die organische Phase zur Trockene eingeengt. Der so erhaltene gelbe Feststoff wird viermal aus Dioxan und zweimal aus Toluol / n-Heptan (2:1, v:v) umkristallisiert, dann zweimal mit 500 ml Ethanol unter Rückfluss ausgerührt und anschließend dreimal im Vakuum (T = 330 °C, p = 5 x 10⁻⁵ mbar) sublimiert. Es werden 17.4 g (24 mmol) (entsprechend 48.3 % d. Th.) des Produkts mit einer Reinheit größer 99.5 % nach HPLC erhalten.

### Beispiel 4: Tris(4-(trimethylsilylphenylvinyl)phenyl)amin (Dotand D4)

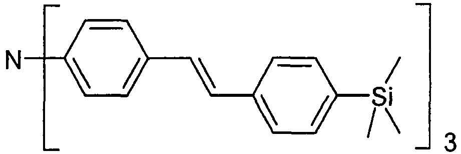

### a) Tris(4-bromphenylvinylphenyl)amin

Ein auf 0 °C gekühltes Gemisch von 179.7 g (585 mmol) Diethyl(4-brombenzyl)phosphonat und 1000 ml DMF wird unter gutem Rühren mit 112.5 g (1.17 mol) Natrium-tert-butylat versetzt. Die Mischung wird 30 min. bei 0 °C nachgerührt und dann tropfenweise mit einer Lösung von 49.6 g (150 mmol) Tris(4-formylphenyl)amin in 1000 ml DMF versetzt. Die Mischung wird 3 h bei 0 bis 5 °C nachgerührt und dann unter Eiskühlung durch Zugabe eines Gemischs aus 250 ml 2.5 M HCl, 600 ml Wasser und 200 ml Ethanol hydrolysiert. Der ausgefallene Feststoff wird abgesaugt, dreimal mit je 300 ml Ethanol / Wasser (1:1, v:v) und dreimal mit je 300 ml Ethanol gewaschen und im Vakuum getrocknet. Der Feststoff wird aus 300 ml DMF umkristallisiert, anschließend mit 500 ml Ethanol ausgekocht und im Vakuum getrocknet. Ausbeute 97.2 g (123 mmol) (entsprechend 82.1 % d. Th.) bei einer Reinheit von 99.0 % nach NMR.

### b) Tris(4-(trimethylsilylphenylvinyl)phenyl)amin

Eine gut gerührte Suspension von 39.4 g (50 mmol) Tris(4-bromphenyl-vinylphenyl)amin in 1000 ml Diethylether wird bei Raumtemperatur tropfenweise mit 100 ml (250 mmol) n-BuLi (2.5 M in n-Hexan) versetzt und 3 h bei Raumtemperatur nachgerührt. Die so erhaltene Lösung wird auf -78 °C abgekühlt, mit einem Gemisch aus 57.5 ml (450 mmol) Chlortrimethylsilan in 100 ml Diethylether versetzt und langsam auf Raumtemperatur erwärmt. Nach Zugabe von 500 ml Wasser wird die organische Phase abgetrennt, über Magnesiumsulfat getrocknet und eingeengt. Der so erhaltene gelbe Feststoff wird fünfmal aus Toluol / Acetonitril umkristallisiert und anschließend dreimal im Vakuum (T = 310 °C, p = 5 x 10⁻⁵ mbar) sublimiert. Es werden 23.6 g (31 mmol) (entsprechend 61.4 % d. Th.) des Produkts mit einer Reinheit größer 99.5 % nach HPLC erhalten.

### Beispiel 5: Tris[((4-boronsäurepinacolester)phenylvinyl)phenyl]amin (Dotand D5)

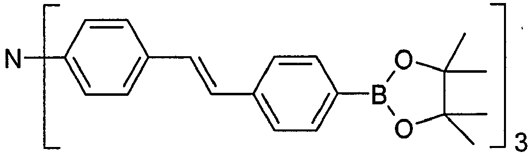

Eine gut gerührte Suspension von 39.4 g (50 mmol) Tris(4-bromphenyl-vinylphenyl)amin (aus Beispiel 4a) in 1000 ml Diethylether wird bei Raumtemperatur tropfenweise mit 100 ml (250 mmol) n-BuLi (2.5 M in n-Hexan) versetzt und 3 h bei Raumtemperatur nachgerührt. Die so erhaltene Lösung wird auf-78 °C abgekühlt, mit einem Gemisch aus 50.2 ml
(450 mmol) Trimethylborat in 100 ml Diethylether versetzt und langsam auf Raumtemperatur erwärmt. Nach Zugabe eines Gemischs von 40 ml Essigsäure und 500 ml Wasser und 30 min. Nachrühren wird die organische Phase abgetrennt und eingeengt. Der so erhaltene gelbe Feststoff wird in 500 ml Toluol suspendiert, mit 17.7 g (150 mmol) Pinakol versetzt und bis zum Ende der Wasserabscheidung gekocht. Das nach Entfernen des Toluols erhaltene Öl wird fünfmal aus Toluol / Acetonitril umkristallisiert und anschließend dreimal im Vakuum (T = 290 °C,
p = 5 x 10⁻⁵ mbar) sublimiert. Es werden 25.1 g (27 mmol) (entsprechend 54.0 % d. Th.) des Produkts mit einer Reinheit größer 99.0 % nach HPLC erhalten.

### Beispiel 6: Tris[((4-trifluormethoxy)phenylvinyl)phenyl]amin (Dotand D6)

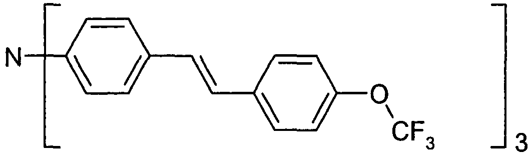

Ein Gemisch aus 24.1 g (50 mmol) Tris-(4-bromphenyl)amin, 30.2 g (225 mmol) 4-Trifluormethoxystyrol, 337 mg (1.5 mmol) Palladium(II)-acetat, 1.55 g (15 mmol) N,N-Dimethylglycin, 81 mg (0.5 mmol) Eisen(III)-chlorid und 37.8 g (450 mmol) Natriumhydrogencarbonat in 500 ml NMP wird langsam unter gutem Rühren auf 140 °C erhitzt und anschließend 24 h bei dieser Temperatur gerührt. Nach Erkalten werden 500 ml Dichlormethan und 1000 ml Wasser zugesetzt. Die organische Phase wird abgetrennt und fünfmal mit 500 ml Wasser gewaschen. Nach Trocknen über Natriumsulfat wird die organische Phase zur Trockene eingeengt. Der so erhaltene gelbe Feststoff fünfmal aus Toluol / n-Heptan (1:1, v:v) umkristallisiert, dann zweimal mit 500 ml Ethanol unter Rückfluss ausgerührt und anschließend dreimal im Vakuum (T = 280 °C, p = 5 x 10⁻⁵ mbar) sublimiert. Es werden 11.0 g (17 mmol) (entsprechend 34.3 % d. Th.) des Produkts mit einer Reinheit größer 99.5 % nach HPLC erhalten.

### Beispiel 7: Tris[4(6-ethenyl-1,2,3,4-tetrahydro-1,1,4,4-tetramethyl-naphthalin)phenyl]amin (Dotand D7)

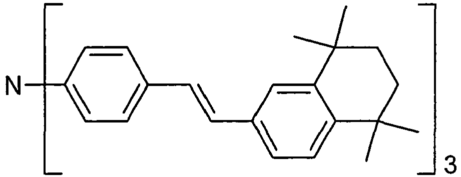

Ein Gemisch aus 24.1 g (50 mmol) Tris-(4-bromphenyl)amin, 48.2 g (225 mmol) 6-Ethenyl-1,2,3,4-tetrahydro-1,1,4,4-tetramethyl-naphthalin, 337 mg (1.5 mmol) Palladium(II)acetat, 1.55 g (15 mmol) N,N-Dimethyl-glycin, 81 mg (0.5 mmol) Eisen(III)chlorid und 37.8 g (450 mmol) Natriumhydrogencarbonat in 500 ml NMP wird langsam unter gutem Rühren auf 140 °C erhitzt und anschließend 16 h bei dieser Temperatur gerührt. Nach Erkalten werden 500 ml Dichlormethan und 1000 ml Wasser zugesetzt. Die organische Phase wird abgetrennt und fünfmal mit 500 ml Wasser gewaschen. Nach Trocknen über Natriumsulfat wird die organische Phase zur Trockene eingeengt. Der so erhaltene gelbe Feststoff wird fünfmal aus Dioxan umkristallisiert, dann zweimal mit 500 ml Ethanol unter Rückfluss ausgerührt und anschließend dreimal im Vakuum (T = 340 °C, p = 5 x 10⁻⁵ mbar) sublimiert. Es werden 24.7 g (28 mmol) (entsprechend 56.0 % d. Th.) des Produkts mit einer Reinheit größer 99.5 % nach HPLC erhalten.

### Beispiel 8: Tris[4-(fluorphenylvinyl)phenyl]amin (Dotand D8)

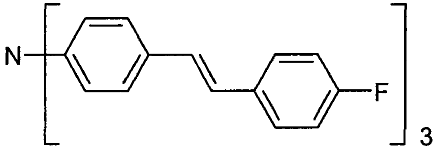

Ein Gemisch aus 24.1 g (50 mmol) Tris-(4-bromphenyl)amin, 26.8 ml (225 mmol) 4-Fluorstyrol, 337 mg (1.5 mmol) Palladium(II)acetat, 1.55 g (15 mmol) N,N-Dimethylglycin, 81 mg (0.5 mmol) Eisen(III)chlorid und 37.8 g (450 mmol) Natriumhydrogencarbonat in 500 ml NMP wird langsam unter gutem Rühren auf 140 °C erhitzt und anschließend 16 h bei dieser Temperatur gerührt. Nach Erkalten werden 500 ml Dichlormethan und 1000 ml Wasser zugesetzt. Die organische Phase wird abgetrennt und fünfmal mit 500 ml Wasser gewaschen. Nach Trocknen über Natriumsulfat wird die organische Phase zur Trockene eingeengt. Der so erhaltene gelbe Feststoff wird fünfmal aus Dioxan umkristallisiert, dann zweimal mit 500 ml Ethanol unter Rückfluss ausgerührt und anschließend dreimal im Vakuum (T = 290 °C, p = 5 x 10⁻⁵ mbar) sublimiert. Es werden 15.4 g (26 mmol) (entsprechend 56.1 % d. Th.) des Produkts mit einer Reinheit größer 99.5 % nach HPLC erhalten.

### Beispiel 9: Herstellung der OLEDs

Die Herstellung von OLEDs erfolgt nach einem allgemeinen Verfahren gemäß WO 04/058911, das im Einzelfall auf die jeweiligen Gegebenheiten (z. B. Schichtdickenvariation, um optimale Effizienz bzw. Farbe zu erreichen) angepasst wird.

In den folgenden Beispielen 10 bis 17 werden die Ergebnisse verschiedener OLEDs vorgestellt. Der grundlegende Aufbau und die verwendeten Materialien (außer der emittierenden Schicht) sind in den Beispielen zur besseren Vergleichbarkeit identisch. Analog dem o. g. allgemeinen Verfahren werden OLEDs mit folgendem Aufbau erzeugt:

| | |
|---|---|
| Lochinjektionsschicht (HIL) | 20 nm PEDOT (aus Wasser aufgeschleudert; bezogen von H. C. Starck, Goslar, Deutschland; Poly(3,4-ethylendioxy-2,5-thiophen)) |
| Lochtransportschicht (HTM) | 10 nm 2,2',7,7'-Tetrakis(di-para-tolylamino)spiro-9,9'-bifluoren (abgekürzt als **HTM-1**) |
| Lochtransportschicht (HTM) | 30 nm NPB (N-Naphthyl-N-phenyl-4,4'-diaminobiphenyl) |
| Emissionschicht (EML) | siehe Tabelle 1 für Materialien, Konzentration und Schichtdicke |
| Elektronenleiter (ETL) | 20 nm AlQ₃ (bezogen von SynTec, Tris(chinolinato)aluminium(III)) |
| Kathode | 1 nm LiF, darauf 150 nm Al |

Diese OLEDs werden standardmäßig charakterisiert; hierfür werden die Elektrolumineszenzspektren, die Effizienz (gemessen in cd/A), die Leistungseffizienz (gemessen in Im/W) in Abhängigkeit der Helligkeit, berechnet aus Strom-Spannungs-Helligkeit-Kennlinien (IUL-Kennlinien), und die Lebensdauer bestimmt. Als Lebensdauer wird die Zeit definiert, nach der die Anfangshelligkeit von 1000 cd/m² auf die Hälfte gesunken ist.

In Tabelle 1 sind die Ergebnisse einiger OLEDs (Beispiele 10 bis 17) zusammengefasst, die die Dotanden **D1** und **D2** (Vergleichsbeispiele) und **D3** bis **D8** (erfindungsgemäße Beispiele) enthalten, wobei jeweils die Zusammensetzung der EML inklusive der Schichtdicken mit aufgeführt ist. Als Hostmaterial wird in allen Fällen 9,10-Bis(1-naphthyl)anthracen (**H1**) eingesetzt, welches im Folgenden dargestellt ist:

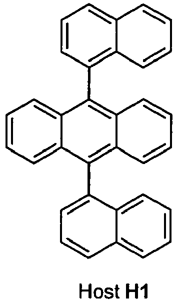

Für diese OLEDs wird dabei der Dotiergrad, also der Anteil des Dotanden im Hostmaterial, jeweils so optimiert, dass die besten Ergebnisse bezüglich Farbe und Lebensdauer erhalten werden. Mit **D1** und **D2** werden die besten Ergebnisse mit einem Dotiergrad von 2 % erhalten, während sich mit 5 % die Farbkoordinaten und die Lebensdauer verschlechtern. Dagegen werden mit **D3** bis **D8** die besten Ergebnisse mit einem Dotiergrad von 5 % erhalten.

Wie man den Beispielen in der Tabelle 1 entnehmen kann, zeigen die erfindungsgemäßen Tristilbenaminderivate tiefblaue Emission mit besseren Farbkoordinaten und verbesserte Effizienz bei deutlich verbesserter Lebensdauer im Vergleich zu den Tristilbenaminderivaten gemäß dem Stand der Technik.

**Tabelle 1**

| **Beispiel** | **HTL1** | **HTL2** | **EML** | **Max Effizienz (cd/A)** | **Spannung (V) bei 100 cd/m²** | **CIE** | **Lebensdauer (h)** |
|---|---|---|---|---|---|---|---|
| Beispiel 10 Verqleich) | **HTM-1** | **NPB** | **H1 : D1** (2%) | 3.4 | 5.1 | x=0.15; y=0.16 | 500 |
| | (10 nm) | (30 nm) | (30 nm) | | | | |
| Beispiel 11 (Vergleich) | **HTM-1** | **NPB** | **H1 : D2** (2%) | 3.6 | 5.0 | x=0.15; y=0.17 | 800 |
| | (10 nm) | (30 nm) | (30 nm) | | | | |
| Beispiel 12 | **HTM-1** | **NPB** | **H1 : D3** (5%) | 4.2 | 5.1 | x=0.15; y=0.11 | 1600 |
| | (10 nm) | (20 nm) | (30 nm) | | | | |
| Beispiel 13 | **HTM-1** | **NPB** | **H1 : D4** (5%) | 4.9 | 4.5 | x=0.15; y=0.13 | 1200 |
| | (10 nm) | (30 nm) | (30 nm) | | | | |
| Beispiel 14 | **HTM-1** | **NPB** | **H1 : D5** (5%) | 4.7 | 4.7 | x=0.15; y=0.14 | 1100 |
| | (10 nm) | (30 nm) | (30 nm) | | | | |
| Beispiel 15 | **HTM-1** | **NPB** | **H1 : D6** (5%) | 4.5 | 4.9 | x=0.15; y=0.13 | 1000 |
| | (10 nm) | (30 nm) | (30 nm) | | | | |
| Beispiel 16 | **HTM-1** | **NPB** | **H1 : D7** (5%) | 4.4 | 5.0 | x=0.15; y=0.12 | 1500 |
| | (10 nm) | (20 nm) | (30 nm) | | | | |
| Beispiel 17 | **HTM-1** | **NPB** | **H1 : D8** (5%) | 4.0 | 5.2 | x=0.15; y=0.14 | 1050 |
| | (10 nm) | (30 nm) | (30 nm) | | | | |

## Patentansprüche

1. Organische Elektrolumineszenzvorrichtung, enthaltend Anode, Kathode und mindestens eine organische Schicht, welche zur Emission von Licht befähigt ist, **dadurch gekennzeichnet, dass** die organische Schicht mindestens eine Verbindung der Formel (1) enthält, 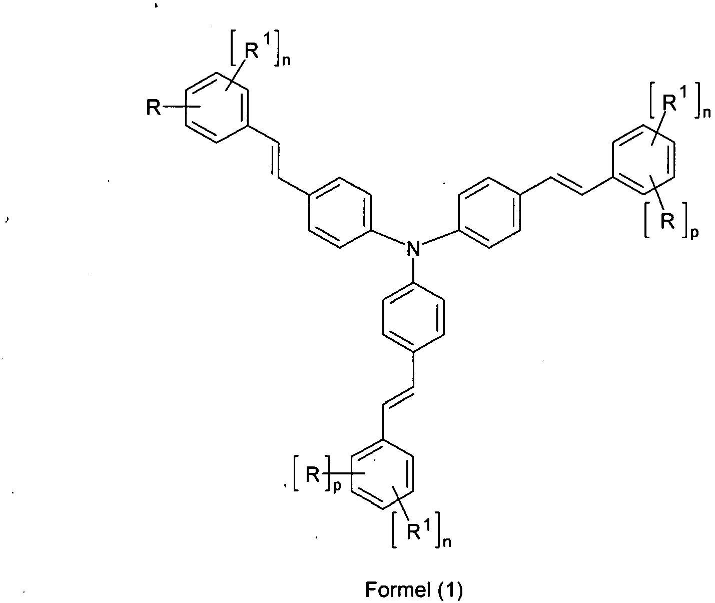 wobei für die verwendeten Symbole und Indizes gilt:
R ist gleich oder verschieden bei jedem Auftreten F, OCF₃, Si(R²)₃, B(OR²)₂ oder eine geradkettige, verzweigte oder cyclische Alkyl-, Alkoxy- oder Thioalkoxygruppe mit 4 bis 10 C-Atomen, die mit einem oder mehreren Resten R¹ substituiert sein kann, wobei eine oder mehrere nicht benachbarte CH₂-Gruppen durch -R²C=CR²-, -C≡C-, Si(R²)₂, Ge(R²)₂, Sn(R²)₂, C=O, C=S, C=Se, C=NR², -O-, -S-, -N(R²)- oder -CONR²- ersetzt sein können und wobei ein oder mehrere H-Atome durch F, Cl, Br, I, CN oder NO₂ ersetzt sein können; wenn R für eine Alkyl-, Alkoxy- oder Thioalkoxygruppe steht, kann R auch zwei Bindungen zur Phenylgruppe aufweisen und dadurch ein cyclisches, kondensiertes Ringsystem aufbauen;
R¹ ist gleich oder verschieden bei jedem Auftreten F, Cl, Br, I, CN, Si(R²)₃, B(OR²)₂, eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch -R²C=CR²-, -C=C-, Si(R²)₂, Ge(R²)₂, Sn(R²)₂, C=O, C=S, C=Se, C=NR², -O-, -S-, -N(R²)- oder -CONR²- ersetzt sein können und wobei ein oder mehrere H-Atome durch F, Cl, Br, I, CN oder NO₂ ersetzt sein können, oder ein aromatisches oder heteroaromatisches Ringsystem mit 5 bis 30 aromatischen Ringatomen, das mit einem oder mehreren Resten R² substituiert sein kann, oder eine Aryloxy- oder Heteroaryloxygruppe mit 5 bis 24 aromatischen Ring-atomen, die durch einen oder mehrere Reste R² substituiert sein kann, oder eine Kombination aus zwei, drei, vier oder fünf dieser Systeme; dabei können auch zwei oder mehrere Substituenten R¹ miteinander ein mono- oder polycyclisches, aliphatisches oder aromatisches Ringsystem bilden;
R² ist bei jedem Auftreten gleich oder verschieden H oder ein Kohlenwasserstoffrest mit 1 bis 20 C-Atomen, der aliphatisch, aromatisch oder eine Kombination aus aliphatisch und aromatisch sein kann und in dem auch einzelne H-Atome durch Fluor ersetzt sein können; dabei können auch zwei oder mehrere Reste R² miteinander ein mono- oder polycyclisches, aliphatisches oder aromatisches Ringsystem bilden;
n ist gleich oder verschieden bei jedem Auftreten 0, 1, 2, 3 oder 4;
p ist gleich oder verschieden bei jedem Auftreten 0 oder 1.

2. Organische Elektrolumineszenzvorrichtung nach Anspruch 1, **dadurch gekennzeichnet, dass** die organische Schicht mindestens eine Verbindung der Formel (1 a) enthält, 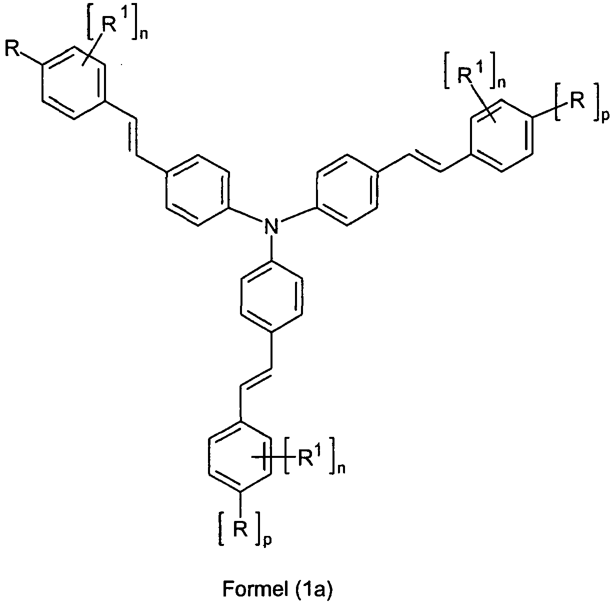 wobei die Symbole und Indizes dieselbe Bedeutung haben, wie unter Anspruch 1 beschrieben.

3. Organische Elektrolumineszenzvorrichtung nach Anspruch 1 oder 2, **dadurch gekennzeichnet, dass** das Symbol R, gleich oder verschieden bei jedem Auftreten, für F, Si(R²)₃, B(OR²)₂ oder eine geradkettige, verzweigte oder cyclische Alkylgruppe mit 4 bis 10 C-Atomen, wobei ein oder mehrere H-Atome durch F ersetzt sein können steht.

4. Organische Elektrolumineszenzvorrichtung nach einem oder mehreren der Ansprüche 1 bis 3, **dadurch gekennzeichnet, dass** die Gruppe R keine benzylischen Protonen enthält oder dass die Gruppe R eine bi- oder polycyclische Alkylgruppe darstellt, welche über ein Brückenkopfatom an die Phenylgruppe gebunden ist.

5. Organische Elektrolumineszenzvorrichtung nach einem oder mehreren der Ansprüche 1 bis 4, **dadurch gekennzeichnet, dass** das Symbol R¹, gleich oder verschieden bei jedem Auftreten, für F, Si(R²)₃, B(OR²)₂, eine geradkettige Alkyl- oder Alkoxygruppe mit 1 bis 6 C-Atomen oder eine verzweigte oder cyclische Alkyl- oder Alkoxygruppe mit 3 bis 10 C-Atomen, wobei jeweils eine oder mehrere CH₂-Gruppen durch -R²C=CR²-, Si(R²)₂, -O-, -S- oder -N(R²)- ersetzt sein können und wobei jeweils ein oder mehrere H-Atome durch F ersetzt sein können, oder eine Aryl- oder Heteroarylgruppe mit 5 bis 14 aromatischen Ringatomen, oder eine Kombination aus zwei oder drei dieser Systeme steht; dabei können auch zwei oder mehrere benachbarte Reste R¹ miteinander ein mono- oder polycyclisches, aliphatisches Ringsystem bilden.

6. Organische Elektrolumineszenzvorrichtung nach einem oder mehreren der Ansprüche 1 bis 5, **dadurch gekennzeichnet, dass** der Index n, gleich oder verschieden bei jedem Auftreten, für 0 oder 1 steht.

7. Organische Elektrolumineszenzvorrichtung nach einem oder mehreren der Ansprüche 1 bis 6, **dadurch gekennzeichnet, dass** die Verbindung gemäß Formel (1) bzw. Formel (1a) eine dreizählige Drehachse aufweist.

8. Organische Elektrolumineszenzvorrichtung nach einem oder mehreren der Ansprüche 1 bis 7, **dadurch gekennzeichnet, dass** die Verbindung der Formel (1) bzw. Formel (1a) in der emittierenden Schicht als Mischung mit einem Hostmaterial verwendet wird.

9. Organische Elektrolumineszenzvorrichtung nach einem oder mehreren der Ansprüche 1 bis 8, **dadurch gekennzeichnet, dass** das Hostmaterial ausgewählt ist aus der Klasse der Oligo-arylene, insbesondere der Oligo-arylene enthaltend kondensierte aromatische Gruppen, der Oligo-arylenvinylene, der polypodalen Metallkomplexe, der lochleitenden Verbindungen, der elektronenleitenden Verbindungen, insbesondere Ketone, Phosphinoxide, Sulfoxide, der Atropisomere oder der Boronsäurederivate.

10. Organische Elektrolumineszenzvorrichtung nach einem oder mehreren der Ansprüche 1 bis 9, **dadurch gekennzeichnet, dass** der Anteil der Verbindung gemäß Formel (1) in der Mischung zwischen 0.5 und 50.0 Gew.-% und der Anteil des Hostmaterials in der Mischung zwischen 50.0 und 99.5 Gew.-% beträgt.

11. Organische Elektrolumineszenzvorrichtung nach einem oder mehreren der Ansprüche 1 bis 10, **dadurch gekennzeichnet, dass** mehrere emittierende Schichten verwendet werden, wobei mindestens eine dieser Schichten mindestens eine Verbindung gemäß Formel (1) enthält.

12. Organische Elektrolumineszenzvorrichtung nach einem oder mehreren der Ansprüche 1 bis 11, **dadurch gekennzeichnet, dass** außer Kathode, Anode und der emittierenden Schicht weitere Schichten enthalten sind, ausgewählt aus Lochinjektionsschicht, Lochtransportschicht, Elektronentransportschicht und/oder Elektroneninjektionsschicht, die jeweils auch dotiert sein können.

13. Verbindungen der Formel (1), 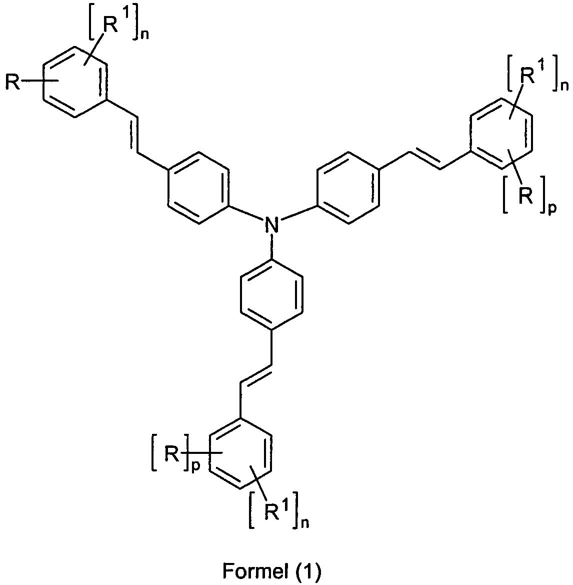 wobei R, R¹, R², n und p dieselbe Bedeutung haben, wie unter Anspruch 1 beschrieben, und wobei die folgende Verbindung von der Erfindung ausgeschlossen ist:

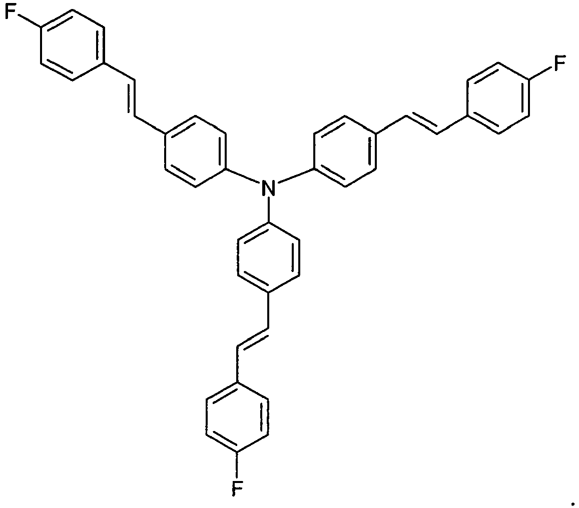

14. Mischungen enthaltend mindestens eine Verbindung nach Anspruch 13 und mindestens ein Hostmaterial.

15. Verwendung von Verbindungen nach Anspruch 13 oder von Mischungen nach Anspruch 14 zur Herstellung von organischen Elektrolumineszenzvorrichtungen.

16. Verfahren zur Herstellung von Verbindungen nach Anspruch 13, **dadurch gekennzeichnet, dass** Tris-(4-bromphenyl)amin mit einem entsprechend substituierten Styrolderivat in einer Heck-Kupplung umgesetzt wird oder dass Tris(4-formylphenyl)amin mit einem entsprechend substituierten Dialkylbenzylphosphonat umgesetzt wird.

## Claims

1. Organic electroluminescent device comprising anode, cathode and at least one organic layer which is capable of the emission of light, **characterised in that** the organic layer comprises at least one compound of the formula (1), 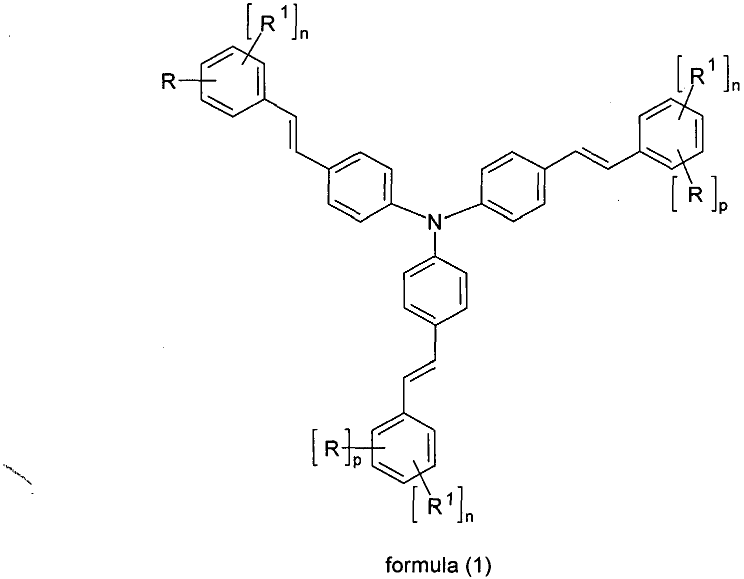 where the following applies to the symbols and indices used:
R is, identically or differently on each occurrence, F, OCF₃, Si(R²)₃, B(OR²)₂ or a straight-chain, branched or cyclic alkyl, alkoxy or thioalkoxy group having 4 to 10 C atoms, which may be substituted by one or more radicals R¹, where one or more non-adjacent CH₂ groups may be replaced by -R²C=CR²-, -C≡C-, Si(R²)₂, Ge(R²)₂, Sn(R²)₂, C=O, C=S, C=Se, C=NR², -O-, -S-, -N(R²)- or -CONR²- and where one or more H atoms may be replaced by F, Cl, Br, I, CN or NO₂; if R stands for an alkyl, alkoxy or thioalkoxy group, R may also have two bonds to the phenyl group and thus build up a cyclic, condensed ring system;
R¹ is, identically or differently on each occurrence, F, Cl, Br, I, CN, Si(R²)₃, B(OR²)₂, a straight-chain alkyl, alkoxy or thioalkoxy group having 1 to 40 C atoms or a branched or cyclic alkyl, alkoxy or thioalkoxy group having 3 to 40 C atoms, each of which may be substituted by one or more radicals R², where one or more non-adjacent CH₂ groups may be replaced by -R²C=CR²-, -C≡C-, Si(R²)₂, Ge(R²)₂, Sn(R²)₂, C=O, C=S, C=Se, C=NR², -O-, -S-, -N(R²)- or -CONR²- and where one or more H atoms may be replaced by F, Cl, Br, I, CN or NO₂, or an aromatic or heteroaromatic ring system having 5 to 30 aromatic ring atoms, which may be substituted by one or more radicals R², or an aryloxy or heteroaryloxy group having 5 to 24 aromatic ring atoms, which may be substituted by one or more radicals R², or a combination of two, three, four or five of these systems; two or more substituents R¹ here may also form a mono- or polycyclic, aliphatic or aromatic ring system with one another;
R² is on each occurrence, identically or differently, H or a hydrocarbon radical having 1 to 20 C atoms, which may be aliphatic, aromatic or a combination of aliphatic and aromatic and in which, in addition, individual H atoms may be replaced by fluorine; two or more radicals R² here may also form a mono- or polycyclic, aliphatic or aromatic ring system with one another;
n is, identically or differently on each occurrence, 0, 1, 2, 3 or 4;
p is, identically or differently on each occurrence, 0 or 1.

2. Organic electroluminescent device according to Claim 1, **characterised in that** the organic layer comprises at least one compound of the formula (1a), 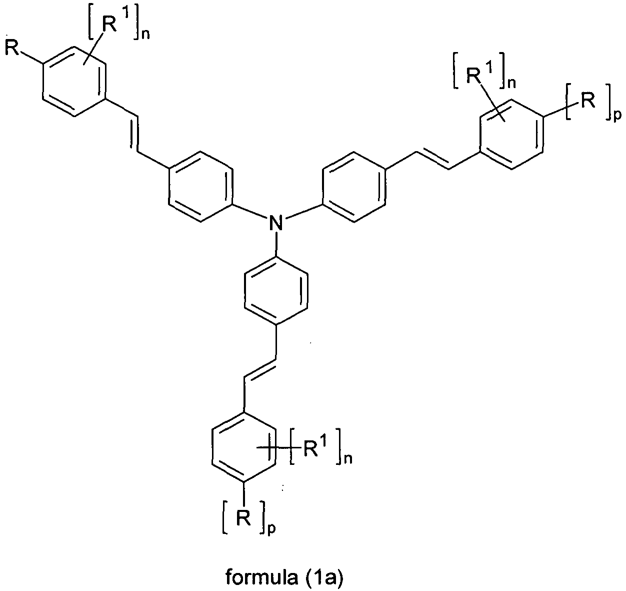 where the symbols and indices have the same meaning as described under Claim 1.

3. Organic electroluminescent device according to Claim 1 or 2, **characterised in that** the symbol R, identically or differently on each occurrence, stands for F, Si(R²)₃, B(OR²)₂ or a straight-chain, branched or cyclic alkyl group having 4 to 10 C atoms, where one or more H atoms may be replaced by F.

4. Organic electroluminescent device according to one or more of Claims 1 to 3, **characterised in that** the group R contains no benzylic protons or **in that** the group R represents a bi- or polycyclic alkyl group which is bonded to the phenyl group via a bridgehead atom.

5. Organic electroluminescent device according to one or more of Claims 1 to 4, **characterised in that** the symbol R¹, identically or differently on each occurrence, stands for F, Si(R²)₃, B(OR²)₂, a straight-chain alkyl or alkoxy group having 1 to 6 C atoms or a branched or cyclic alkyl or alkoxy group having 3 to 10 C atoms, where in each case one or more CH₂ groups may be replaced by -R²C=CR²-, Si(R²)₂, -O-, -S- or -N(R²)- and where in each case one or more H atoms may be replaced by F, or an aryl or heteroaryl group having 5 to 14 aromatic ring atoms, or a combination of two or three of these systems; two or more adjacent radicals R¹ here may also form a mono- or polycyclic, aliphatic ring system with one another.

6. Organic electroluminescent device according to one or more of Claims 1 to 5, **characterised in that** the index n, identically or differently on each occurrence, stands for 0 or 1.

7. Organic electroluminescent device according to one or more of Claims 1 to 6, **characterised in that** the compound of the formula (1) or formula (1a) has a threefold axis of rotation.

8. Organic electroluminescent device according to one or more of Claims 1 to 7, **characterised in that** the compound of the formula (1) or formula (1a) is used as a mixture with a host material in the emitting layer.

9. Organic electroluminescent device according to one or more of Claims 1 to 8, **characterised in that** the host material is selected from the class of the oligoarylenes, in particular the oligoarylenes containing condensed aromatic groups, the oligoarylenevinylenes, the poly-podal metal complexes, the hole-conducting compounds, the electron-conducting compounds, in particular ketones, phosphine oxides or sulfoxides, the atropisomers or the boronic acid derivatives.

10. Organic electroluminescent device according to one or more of Claims 1 to 9, **characterised in that** the proportion of the compound of the formula (1) in the mixture is between 0.5 and 50.0% by weight and the proportion of the host material in the mixture is between 50.0 and 99.5% by weight.

11. Organic electroluminescent device according to one or more of Claims 1 to 10, **characterised in that** a plurality of emitting layers are used, where at least one of these layers comprises at least one compound of the formula (1).

12. Organic electroluminescent device according to one or more of Claims 1 to 11, **characterised in that**, apart from the cathode, the anode and the emitting layer, further layers are present, selected from hole-injection layer, hole-transport layer, electron-transport layer and/or electron-injection layer, each of which may also be doped.

13. Compounds of the formula (1), 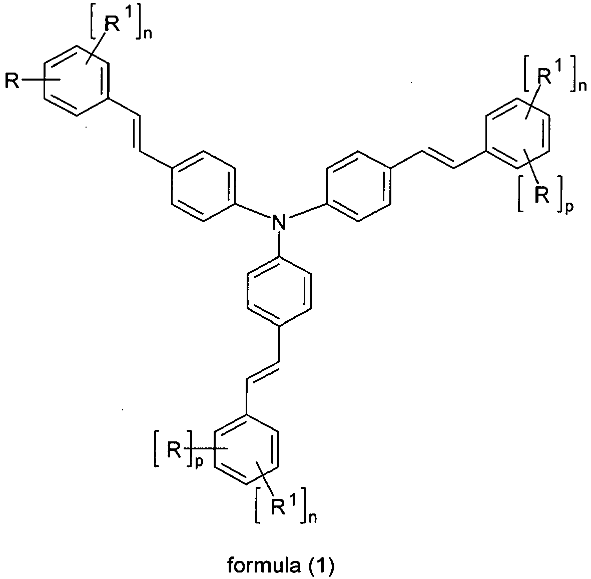 where R, R¹, R², n and p have the same meaning as described under Claim 1, and where the following compound is excluded from the invention:

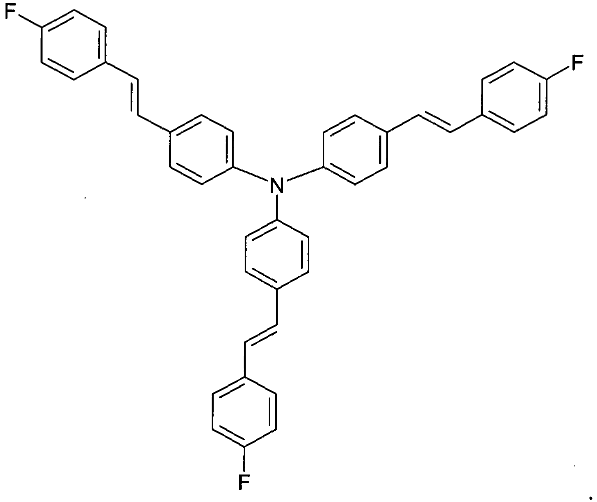

14. Mixtures comprising at least one compound according to Claim 13 and at least one host material.

15. Use of compounds according to Claim 13 or of mixtures according to Claim 14 for the production of organic electroluminescent devices.

16. Process for the preparation of compounds according to Claim 13, **characterised in that** tris(4-bromophenyl)amine is reacted with an appropriately substituted styrene derivative in a Heck coupling or **in that** tris(4-formylphenyl)amine is reacted with an appropriately substituted dialkyl benzylphosphonate.

## Revendications

1. Dispositif électroluminescent organique comprenant une anode, une cathode et au moins une couche organique qui dispose d'une capacité d'émission de lumière, **caractérisé en ce que** la couche organique comprend au moins un composé de la formule (1): 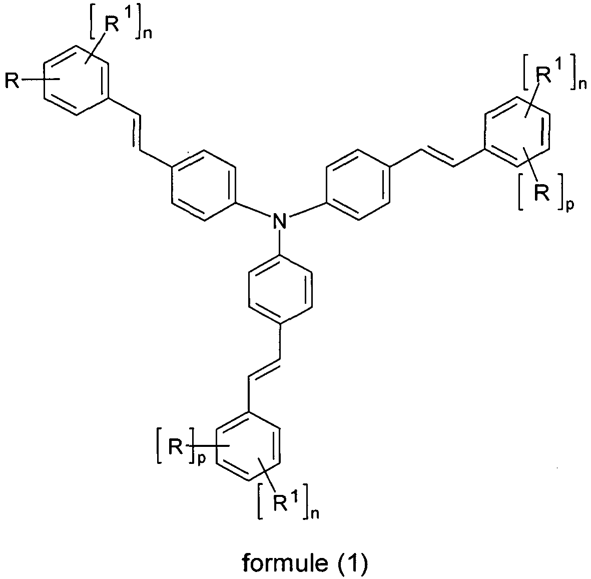 dans laquelle ce qui suit s'applique aux symboles et indices utilisés :
R est, de manière identique ou différente pour chaque occurrence, F, OCF₃, Si(R²)₃, B(OR²)₂ ou un groupe alkyle, alcoxy ou thioalcoxy en chaîne droite, ramifié ou cyclique comportant 4 à 10 atomes de C, lequel peut être substitué par un radical ou plusieurs radicaux R¹, où un ou plusieurs groupe(s) CH₂ non adjacents peut/peuvent être remplacé(s) par -R²C=CR²-, -C≡C-, Si(R²)₂, Ge(R²)₂, Sn(R²)₂, C=O, C=S, C=Se, C=NR², -O-, -S-, -N(R²)- ou -CONR²- et où un ou plusieurs atome(s) de H peut/ peuvent être remplacé(s) par F, Cl, Br, I, CN ou NO₂ ; si R représente un groupe alkyle, alcoxy ou thioalcoxy, R peut également comporter deux liaisons sur le groupe phényle et peut par conséquent constituer un système condensé cyclique ;
R¹ est, de manière identique ou différente pour chaque occurrence, F, Cl, Br, I, CN, Si(R²)₃, B(OR²)₂, un groupe alkyle, alcoxy ou thioalcoxy en chaîne droite comportant 1 à 40 atome(s) de C ou un groupe alkyle, alcoxy ou thioalcoxy ramifié ou cyclique comportant 3 à 40 atomes de C, dont chacun peut être substitué par un radical ou plusieurs radicaux R², où un ou plusieurs groupe(s) CH₂ non adjacents peut/peuvent être remplacé(s) par -R²C=CR²-, -C≡C-, Si(R²)₂, Ge(R²)₂, Sn(R²)₂, C=O, C=S, C=Se, C=NR², -O-, -S-, -N(R²)- ou -CONR²- et où un ou plusieurs atome(s) de H peut/peuvent être remplacé(s) par F, Cl, Br, I, CN ou NO₂, ou un système de cycle aromatique ou hétéroaromatique comportant 5 à 30 atomes de cycle aromatique, lequel peut être substitué par un radical ou plusieurs radicaux R², ou un groupe aryloxy ou hétéroaryloxy comportant 5 à 24 atomes de cycle aromatique, lequel peut être substitué par un radical ou plusieurs radicaux R², ou une combinaison de deux, trois, quatre ou cinq de ces systèmes ; deux substituants R¹ ou plus peuvent ici également former un système de cycle aliphatique ou aromatique monocyclique ou polycyclique l'un avec l'autre ou les uns avec les autres ;
R² est pour chaque occurrence, de manière identique ou différente, H ou un radical hydrocarbone comportant 1 à 20 atome(s) de C, lequel peut être aliphatique, aromatique ou une combinaison d'aliphatique et d'aromatique et où, en outre, des atomes de H individuels peuvent être remplacés par fluor ; deux radicaux R² ou plus peuvent ici également former un système de cycle aliphatique ou aromatique monocyclique ou polycyclique l'un avec l'autre ou les uns avec les autres ;
n est, de manière identique ou différente pour chaque occurrence, 0, 1,2, 3 ou 4 ;
p est, de manière identique ou différente pour chaque occurrence, 0 ou 1.

2. Dispositif électroluminescent organique selon la revendication 1, **caractérisé en ce que** la couche organique comprend au moins un composé de la formule (1a) : 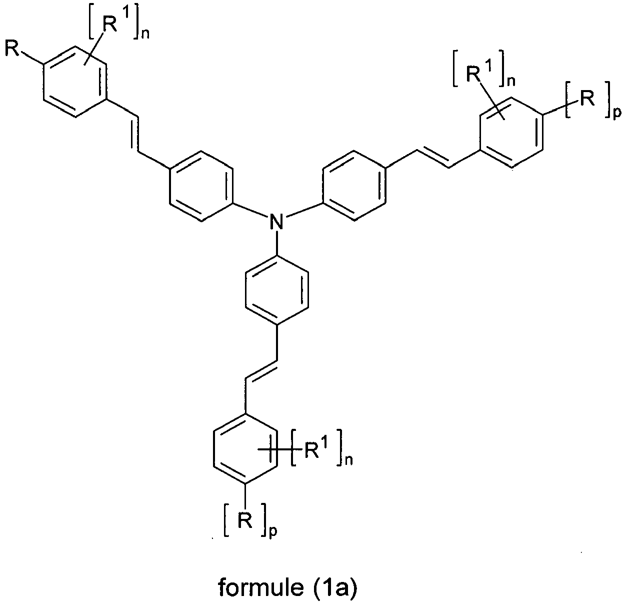 dans laquelle les symboles et indices présentent la même signification que décrite selon la revendication 1.

3. Dispositif électroluminescent organique selon la revendication 1 ou 2, **caractérisé en ce que** le symbole R, de manière identique ou différente pour chaque occurrence, représente F, Si(R²)₃, B(OR²)₂ ou un groupe alkyle en chaîne droite, ramifié ou cyclique comportant 4 à 10 atomes de C, où un ou plusieurs atome(s) de H peut/peuvent être remplacé(s) par F.

4. Dispositif électroluminescent organique selon une ou plusieurs des revendications 1 à 3, **caractérisé en ce que** le groupe R ne contient pas de protons benzyliques ou **en ce que** le groupe R représente un groupe alkyle bicyclique ou polycyclique qui est lié au groupe phényle via un atome de tête de pont.

5. Dispositif électroluminescent organique selon une ou plusieurs des revendications 1 à 4, **caractérisé en ce que** le symbole R¹, de manière identique ou différente pour chaque occurrence, représente F, Si(R²)₃, B(OR²)₂, un groupe alkyle ou alcoxy en chaîne droite comportant 1 à 6 atome(s) de C ou un groupe alkyle ou alcoxy ramifié ou cyclique comportant 3 à 10 atomes de C, où, dans chaque cas, un ou plusieurs groupe(s) CH₂ peut/peuvent être remplacé(s) par -R²C=CR²-, Si(R²)₂, -O-, -S- ou -N(R²)- et où, dans chaque cas, un ou plusieurs atome(s) de H peut/peuvent être remplacé(s) par F, ou un groupe aryle ou hétéroaryle comportant 5 à 14 atomes de cycle aromatique, ou une combinaison de deux ou trois de ces systèmes; deux radicaux R¹ adjacents ou plus peuvent ici également former un système de cycle aliphatique monocyclique ou polycyclique l'un avec l'autre ou les uns avec les autres.

6. Dispositif électroluminescent organique selon une ou plusieurs des revendications 1 à 5, **caractérisé en ce que** l'indice n, de manière identique ou différente pour chaque occurrence, représente 0 ou 1.

7. Dispositif électroluminescent organique selon une ou plusieurs des revendications 1 à 6, **caractérisé en ce que** le composé de la formule (1) ou de la formule (1 a) présente un axe de rotation triple.

8. Dispositif électroluminescent organique selon une ou plusieurs des revendications 1 à 7, **caractérisé en ce que** le composé de la formule (1) ou de la formule (1 a) est utilisé en tant que mélange avec un matériau hôte dans la couche d'émission.

9. Dispositif électroluminescent organique selon une ou plusieurs des revendications 1 à 8, **caractérisé en ce que** le matériau hôte est choisi parmi la classe constituée par les oligoarylènes, en particulier les oligoarylènes contenant des groupes aromatiques condensés, les oligoarylènevinylènes, les complexes métalliques polypodaux, les composés de conduction de trous, les composés de conduction d'électrons, en particulier les cétones, les oxydes ou sulfoxydes de phosphine, les atropisomères ou les dérivés d'acide boronique.

10. Dispositif électroluminescent organique selon une ou plusieurs des revendications 1 à 9, **caractérise en ce que** la proportion du composé de la formule (1) dans le mélange est entre 0,5 et 50,0% en poids et la proportion du matériau hôte dans le mélange est entre 50,0 et 99,5% en poids.

11. Dispositif électroluminescent organique selon une ou plusieurs des revendications 1 à 10, **caractérisé en ce qu'**une pluralité de couches d'émission sont utilisées, où au moins l'une de ces couches comprend au moins un composé de la formule (1).

12. Dispositif électroluminescent organique selon une ou plusieurs des revendications 1 à 11, **caractérisé en ce que**, indépendamment de la cathode, de l'anode et de la couche d'émission, d'autres couches sont présentes, choisies parmi une couche d'injection de trous, une couche de transport de trous, une couche de transport d'électrons et/ou une couche d'injection d'électrons dont chacune peut également être dopée.

13. Composés de la formule (1) : 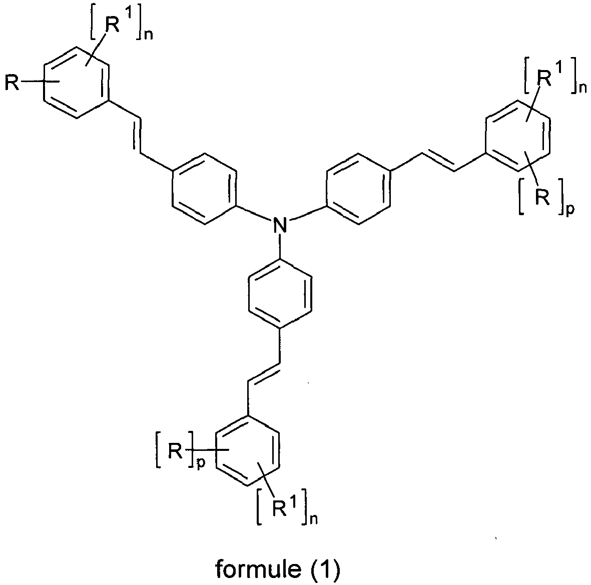 dans laquelle R, R¹, R², n et p présentent la même signification que décrite selon la revendication 1, et où le composé qui suit est exclus de l'invention :

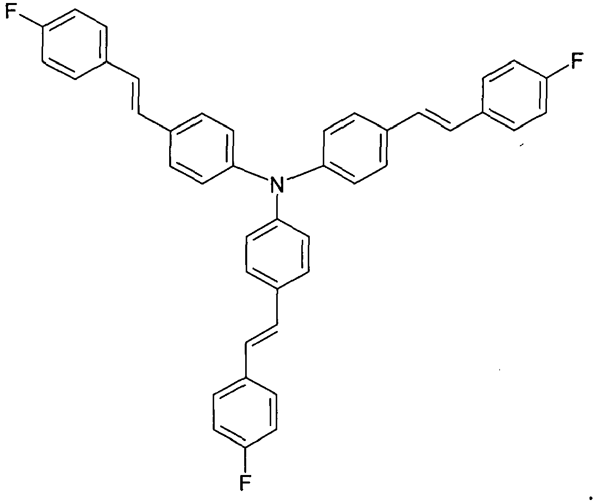

14. Mélanges comprenant au moins un composé selon la revendication 13 et au moins un matériau hôte.

15. Utilisation de composés selon la revendication 13 ou de mélanges selon la revendication 14 pour la production de dispositifs électroluminescents organiques.

16. Procédé pour la préparation de composés selon la revendication 13, **caractérisé en ce que** du tris(4-bromophényl)amine est amené à réagir avec un dérivé de styrène substitué de manière appropriée selon un couplage de Heck ou **en ce que** du tris(4-formylphényl)amine est amené à réagir avec un dialkylbenzylphosphonate substitué de manière appropriée.
